# EUROPÄISCHE PATENTSCHRIFT

(11) **EP 2 435 353 B1**
(45) Veröffentlichungstag und Bekanntmachung des Hinweises auf die Patenterteilung: **19.11.2014**
(21) Anmeldenummer: 10720157.6
(22) Anmeldetag: 18.05.2010
(51) Int. Cl.: B81B 3/00

(54) **MIKROMECHANISCHES BAUTEIL UND HERSTELLUNGSVERFAHREN FÜR EIN MIKROMECHANISCHES BAUTEIL**
MICROMECHANICAL COMPONENT AND PRODUCTION METHOD FOR A MICROMECHANICAL COMPONENT
PIÈCE MICROMÉCANIQUE ET PROCÉDÉ DE PRODUCTION D'UNE PIÈCE MICROMÉCANIQUE

(30) Priorität: 27.05.2009 DE 102009026507
(43) Veröffentlichungstag der Anmeldung: 04.04.2012
(73) Patentinhaber: Robert Bosch GmbH, 70442 Stuttgart (DE)
(72) Erfinder: NJIKAM NJIMONZIE, Frederic, 72762 Reutlingen (DE); SCHOCK, Wolfram, 72768 Rommelsbach (DE); MUCHOW, Joerg, 72764 Reutlingen (DE); LESTYAN, Zoltan, H-1139 Budapest (HU)
(86) Internationale Anmeldenummer: PCT/EP2010/056813
(87) Internationale Veröffentlichungsnummer: WO 2010/136358

(56) Entgegenhaltungen:
- DE-A1-102006 061 762
- US-A1- 2005 002 084
- US-A1- 2006 119 216
- US-A1- 2006 227 553

## Beschreibung

Die Erfindung betrifft ein mikromechanisches Bauteil gemäß dem Oberbegriff des Patentanspruchs 1. Des Weiteren betrifft die Erfindung ein Herstellungsverfahren für ein mikromechanisches Bauteil.

### Stand der Technik

Ein mikromechanisches Bauteil weist häufig einen elektrostatischen und/oder magnetischen Antrieb auf, welcher dazu ausgelegt ist, mindestens ein verstellbares Elements in Bezug auf eine Halterung des mikromechanischen Bauteils um mindestens eine Drehachse zu verstellen. Ein derartiges mikromechanisches Bauteil kann beispielsweise als Mikrospiegel ausgebildet sein. Nachfolgend wird ein Mikrospiegel einer noch unveröffentlichten Anmeldung EP 08400007.4 als Beispiel für ein mikromechanisches Bauteil beschrieben:

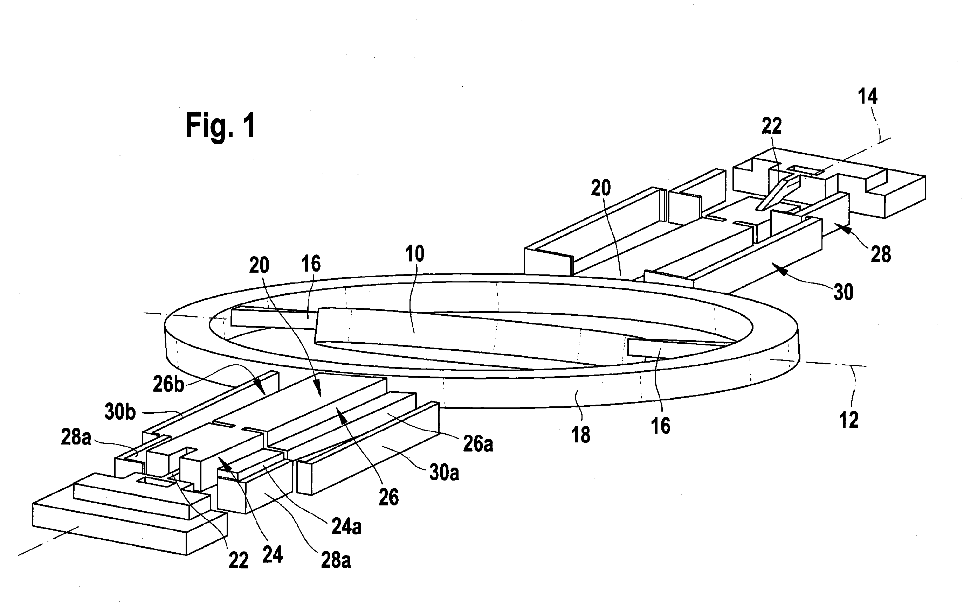

Fig. 1 zeigt eine schematische Darstellung eines herkömmlichen Mikrospiegels.

Der dargestellte Mikrospiegel weist als verstellbares Element eine Spiegelplatte 10 auf, welche in Bezug auf eine (nicht skizzierte) Halterung um eine erste Drehachse 12 und eine zweite Drehachse 14 verstellbar ist. Die Spiegelplatte 10 ist über zwei entlang der ersten Drehachse 12 verlaufende Innenfedern 16 mit einem Innenrahmen 18 verbunden. An zwei gegenüber liegenden Stellen des Innenrahmens 18 sind Stege 20 befestigt, welche entlang der zweiten Drehachse 14 verlaufen. Jeder der beiden Stege 20 ist an seinem dem Innenrahmen 18 entgegen gerichteten Ende über eine Außenfeder 22, welche jeweils entlang der zweiten Drehachse 14 verläuft, mit der Halterung verbunden.

Zusätzlich ist an jedem der Stege 20 eine äußere Aktor-Elektrodenkomponente 24 und eine innere Aktor-Elektrodenkomponente 26 angeordnet. Die äußere Aktor-Elektrodenkomponente 24 umfasst Elektrodenfinger 24a, welche sich beidseitig von dem zugeordneten Steg 20 senkrecht zu der zweiten Drehachse 14 erstrecken. Entsprechend sind auch die Elektrodenfinger 26a und 26b der inneren Aktor-Elektrodenkomponente 26 senkrecht zu der zweiten Drehachse 14 ausgerichtet, wobei die Elektrodenfinger 26a auf einer ersten Seite der zweiten Drehachse 14 und die Elektrodenfinger 26b auf einer zweiten Seite der zweiten Drehachse 14 angeordnet sind. Bei dem dargestellten Beispiel der Fig. 1 weisen die Elektrodenfinger 24a der äußeren Aktor-Elektrodenkomponente 24 eine konstante Länge auf. Die Längen der Elektrodenfinger 26a und 26b der inneren Aktor-Elektrodenkomponente 26 nehmen mit zunehmendem Abstand von dem Innenrahmen 18 ab.

An der Halterung sind jeweils zwei äußere Stator-Elektrodenkomponenten 28 und zwei innere Stator-Elektrodenkomponenten 30 befestigt. Jeweils eine äußere Stator-Elektrodenkomponente 28 ist benachbart zu einer zugeordneten äußeren Aktor-Elektrodenkomponente 24 angeordnet. Entsprechend ist auch jeder der beiden inneren Stator-Elektrodenkomponenten 30 eine innere Aktor-Elektrodenkomponente 26 zugeordnet. Jede der Stator-Elektrodenkomponenten 28 und 30 umfasst Elektrodenfinger 28a, 30a und 30b.

Bei dem dargestellten Mikrospiegel kann zwischen den Elektrodenfingern 24a einer äußeren Aktor-Elektrodenkomponente 24 und den Elektrodenfingern 28a der zugeordneten äußeren Stator-Elektrodenkomponente 28 eine erste Spannung ungleich Null angelegt werden. Erfolgt das Anlegen der ersten Spannung zwischen den auf einer ersten Seite der ersten Drehachse 12 angeordneten Elektrodenfingern 24a und 28a der äußeren Elektrodenkomponenten 24 und 28, so wird die Spiegelplatte 10 in eine erste Drehrichtung um die erste Drehachse 12 verstellt. Entsprechend wird die Spiegelplatte 10 bei einem Anlegen der ersten Spannung zwischen den Elektrodenfingern 24a und 28a der äußeren Elektrodenkomponenten 24 und 28 auf einer zweiten Seite der ersten Drehachse 12 in eine zweite Drehrichtung um die erste Drehachse 12 gedreht.

Die Elektrodenfinger 26a, 26b, 30a und 30b der inneren Elektrodenkomponenten 26 und 30 sind so kontaktierbar, dass lediglich zwischen den auf der ersten Seite der zweiten Drehachse 14 angeordneten Elektrodenfingern 26a und 30a beider innerer Elektrodenkomponenten 26 und 30 eine zweite Spannung anlegbar ist. Unabhängig davon ist die zweite Spannung auch lediglich zwischen den auf der zweiten Seite der Drehachse 14 angeordneten Elektrodenfingern 26b und 30b beider innerer Elektrodenkomponenten 26 und 30 anlegbar. Abhängig von dem Anlegen der zweiten Spannung zwischen den auf der ersten Seite der zweiten Drehachse 14 angeordneten Elektrodenfingern 26a und 30a oder zwischen den auf der zweiten Seite der Drehachse 14 angeordneten Elektrodenfingern 26b und 30b wird die Spiegelplatte 10 in eine bestimmte Drehrichtung um die zweite Drehachse 14 verstellt.

Zur besseren Veranschaulichung der Nachteile des herkömmlichen Mikrospiegels der Fig. 1 wird auf die nachfolgenden Figuren verwiesen.

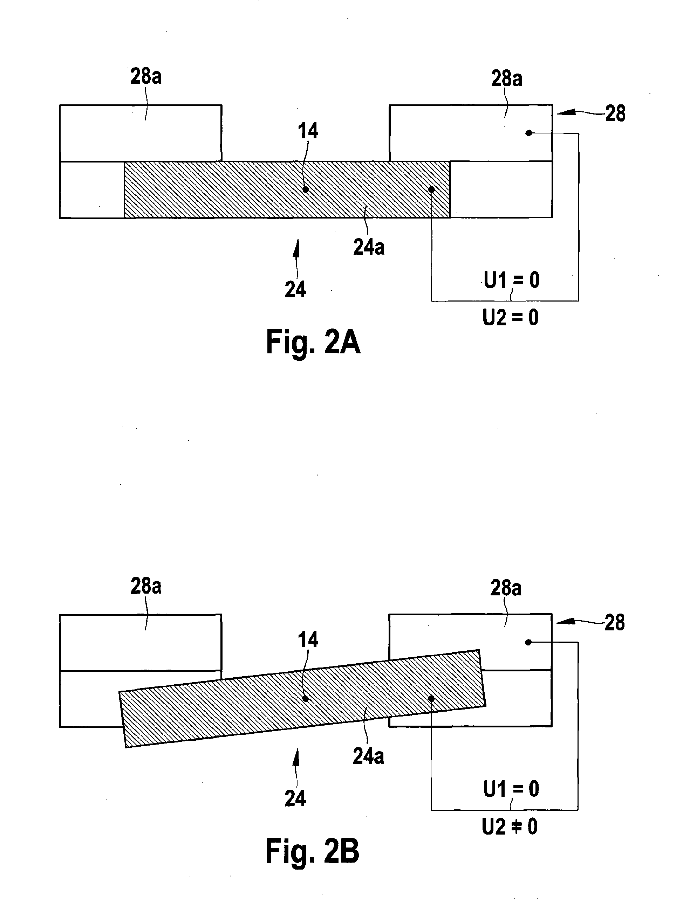

Fig. 2A und 2B zeigen Querschnitte durch eine äußere Aktor-Elektrodenkomponente des herkömmlichen Mikrospiegels der Fig. 1.

Bei den schematischen Darstellungen der Fig. 2A und 2B liegt zwischen den Elektrodenfingern 24a der äußeren Aktor-Elektrodenkomponenten 24 und den Elektrodenfingern 28a der äußeren Stator-Elektrodenkomponenten 28 eine erste Spannung U1 gleich Null an. In Fig. 2A ist auch die zwischen den Elektrodenfingern 26a und 30a oder zwischen den Elektrodenfingern 26b und 30b der inneren Elektrodenkomponenten 26 und 30 anlegbare zweite Spannung U2 gleich Null. Im spannungslosen Zustand, in welchem die anlegbaren Spannungen U1 und U2 gleich Null sind, liegen die Elektrodenfinger 24a und 28a der äußeren Elektrodenkomponenten 24 und 28 parallel zueinander in zwei unterschiedlichen Ebenen. Man spricht dabei auch von einer Out-Of-Plane-Anordnung der Elektrodenfinger 26a und 28a der äußeren Elektrodenkomponenten 24 und 28 im spannungslosen Zustand.

Demgegenüber zeigt Fig. 2B eine Situation, in welcher zwischen den auf der ersten Seite der zweiten Drehachse 14 angeordneten Elektrodenfingern 26a und 30a der inneren Elektrodenkomponenten 26 und 30 eine zweite Spannung U2 ungleich Null angelegt ist. Wie zu erkennen ist, bewirkt das Anlegen einer zweiten Spannung U2 ungleich Null zwischen den (nicht dargestellten) Elektrodenfingern 26a und 30a oder 26b und 30b der inneren Elektrodenkomponenten 26 und 30 auch ein Verstellen der Elektrodenfinger 24a der äußeren Aktor-Elektrodenkomponente 24 um die zweite Drehachse 14. Dies kann beispielsweise zu einer Überlappung der auf der ersten Seite der zweiten Drehachse 14 angeordneten Elektrodenfinger 24a und 28a der äußeren Elektrodenkomponenten 24 und 28 führen, während die auf der zweiten Seite der zweiten Drehachse 14 angeordneten Elektrodenfingern 24a und 28a der äußeren Elektrodenkomponenten 24 und 28 sich nicht überlappen. Wird bei einer derartigen Situation, wie sie in Fig. 2B gezeigt ist, eine erste Spannung U1 ungleich Null zwischen den Elektrodenfingern 24a und 28a der äußeren Elektrodenkomponenten 24 und 28 angelegt, so bewirkt die angelegte erste Spannung U1 zusätzlich ein Übersprech-Drehmoment um die zweiten Drehachse. Dieses Übersprech-Drehmoment führt oft zu einem unerwünschten Verstellen der Spiegelplatte 10 um die zweite Drehachse 14. Man kann dies auch als ein Übersprechen des Mikrospiegels oder als eine unerwünschte Kopplung zwischen den möglichen Verstellbewegungen der Spiegelplatte 10 um die beiden Drehachsen 12 und 14 bezeichnen. Nachteilig ist dabei, dass dieser Effekt mit einer Steigerung der angelegten zweiten Spannung U2, bzw. mit einer Steigerung des zweiten Spiegelverstellwinkels, um welchen die Spiegelplatte 10 um die zweite Drehachse 14 verstellt wird, zunimmt. Es ist deshalb wünschenswert, über ein über gattungsgemäßes mikromechanisches Bauteil zu verfügen, bei welchem keine Kopplung zwischen den beiden möglichen Verstellbewegungen des verstellbaren Elements vorliegt.

Ein mikromechanisches Bauteil mit zwei Drehachsen ist auch aus Dokument US 2005/0002084 A1 bekannt.

### Offenbarung der Erfindung

Die Erfindung schafft ein mikromechanisches Bauteil mit den Merkmalen des Anspruchs 1 und ein Herstellungsverfahren für ein mikromechanisches Bauteil mit den Merkmalen des Anspruchs 11.

Durch die zwischen der äußeren Aktor-Elektrodenkomponente und der inneren Aktor-Elektrodenkomponente angeordnete Zwischenfeder ist gewährleistet, dass die äußere Aktor-Elektrodenkomponente bei einem Verstellen der benachbarten inneren Aktor-Elektrodenkomponente um die zweite Drehachse nicht oder kaum mitbewegt wird. Die äußere Aktor-Elektrodenkomponente ist somit von der Drehbewegung der benachbarten inneren Aktor-Elektrodenkomponente um die zweite Drehachse entkoppelt. Somit bewirkt die Drehbewegung der inneren Aktor-Elektrodenkomponente um die zweite Drehachse keinen bezüglich der zweiten Drehachse unsymmetrischen Überlapp zwischen den äußeren Elektrodenkomponenten. Das Anlegen einer ersten Spannung ungleich Null zwischen den äußeren Elektrodenkomponenten kann deshalb auch kein signifikantes Übersprech-Drehmoment um die zweite Drehachse bewirken, wie dies beim oben beschriebenen Stand der Technik der Fall ist. Damit ist gewährleistet, dass die unerwünschte Kopplung zwischen den beiden möglichen Verstellbewegungen des verstellbaren Elements gut unterbunden ist. Die vorliegende Erfindung bietet somit eine einfach und kostengünstig ausführbare Möglichkeit zum Verhindern des herkömmlicherweise häufig auftretenden Übersprechens.

Im Unterschied zu dem oben beschriebenen herkömmlichen Mikrospiegel ist über die vorliegende Erfindung ein mikromechanisches Bauteil realisierbar, bei welchem entlang des ersten Steges ausschließlich Elektrodenfinger der inneren Aktor-Elektrodenkomponente ausgebildet sind. Auf diese Weise ist ein auf das verstellbare Element ausübbares Drehmoment zum Verstellen des verstellbaren Elements um die zweite Drehachse gegenüber der Gesamtlänge des ersten Stegs signifikant steigerbar. Somit kann der Nachteil, dass viele der Elektrodenfinger der inneren Aktor-Elektrodenkomponente in einem vergleichsweise kleinen Abstand zu der zweiten Drehachse angeordnet werden, behoben werden.

Des Weiteren kann die äußere Aktor-Elektrodenkomponente einen zweiten Steg mit Elektrodenfingern aufweisen, welcher vorzugsweise nicht-parallel zu dem ersten Steg der inneren Aktor-Elektrodenkomponente und/oder zu der ersten Drehachse ausgerichtet ist. Da die Elektrodenfinger der äußeren Aktor-Elektrodenkomponente in diesem Fall in einem vorteilhaft großen Abstand zu der ersten Drehachse angeordnet sind, ist ein hohes Drehmoment zum Verstellen des verstellbaren Elements um die erste Drehachse realisierbar. Zusätzlich kann eine bei einer nicht-parallelen Ausrichtung des ersten Stegs und des zweiten Stegs eine größere Anzahl von Elektrodenfingern an den beiden Stegen angeordnet werden, ohne dass dies eine Vergrößerung des mikromechanischen Bauteils entlang der ersten Drehachse und/oder der zweiten Drehachse erfordert. Durch die relativ große Anzahl von Elektrodenfingern der Elektrodenkomponente ist ein vergleichsweise großer Krafteintrag realisierbar. Somit ist mittels des mikromechanischen Bauteils auch ein verstellbares Element mit einer vergleichsweise großen Masse verstellbar. Zusätzlich können die Federsteifigkeiten der mindestens einen Innenfeder, der mindestens einen Zwischenfeder und/oder der mindestens einen Außenfeder vergleichsweise hoch festgelegt werden, so dass das mikromechanische Bauteil relativ robust ausführbar ist.

Vorteilhafte Weiterbildungen der vorliegenden Erfindung werden in den Unteransprüchen beschrieben.

Die Vorteile des mikromechanischen Bauteils sind auch bei einem entsprechenden Herstellungsverfahren für ein mikromechanisches Bauteil gewährleistet.

### Kurze Beschreibung der Zeichnungen

Weitere Merkmale und Vorteile der vorliegenden Erfindung werden nachfolgend anhand der Figuren erläutert. Es zeigen:
- Fig. 1, Fig. 2A und 2B: eine schematische Darstellung und Querschnitte eines herkömmlichen Mikrospiegels;
- Fig. 3, 4 und 6 bis 13B: schematische Darstellungen von Ausführungsformen des mikromechanischen Bauteils; und
- Fig. 5: einen Querschnitt durch einen Schichtaufbau zum Darstellen einer Ausführungsform des Herstellungsverfahrens.

### Ausführungsformen der Erfindung

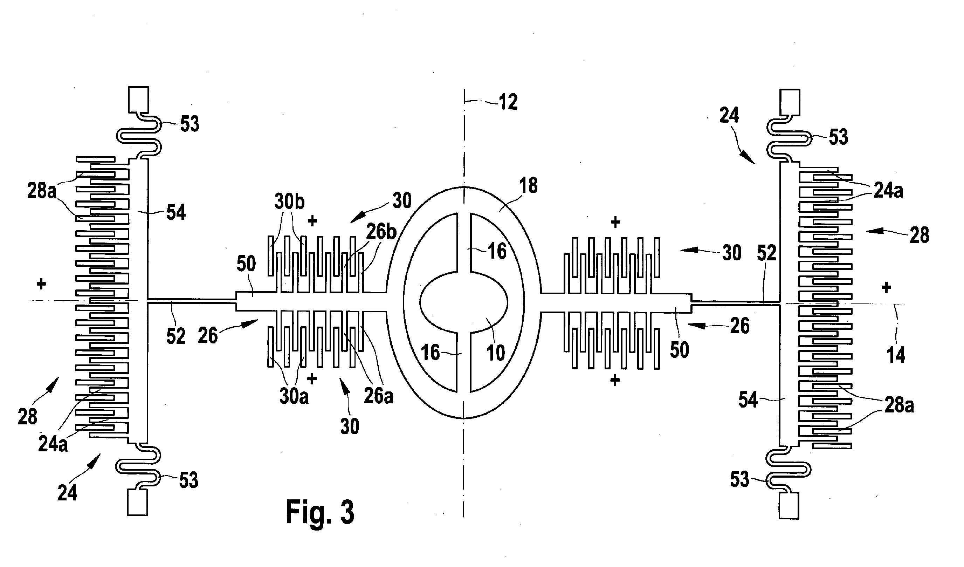

Fig. 3 zeigt eine schematische Darstellung einer ersten Ausführungsform des mikromechanischen Bauteils.

Das dargestellte mikromechanische Bauteil ist als Mikrospiegel ausgebildet. Als verstellbares Element weist das mikromechanische Bauteil eine Spiegelplatte 10 auf. Über eine Polierung und/oder eine geeignete Beschichtung der Spiegelplatte 10 ist ein vorteilhafter Reflektionskoeffizient gewährleistbar.

Es wird darauf hingewiesen, dass das mikromechanische Bauteil nicht auf eine Ausbildung als Mikrospiegel beschränkt ist. Anstelle oder zusätzlich zu der Spiegelplatte 10 kann das mikromechanische Bauteil auch ein anderes verstellbares Element aufweisen.

Die Spiegelplatte 10 ist um eine erste Drehachse 12 und um eine zweite Drehachse 14 in Bezug auf eine (nicht dargestellte) Halterung verstellbar. Die zweite Drehachse 14 ist nicht-parallel zu der ersten Drehachse 12 ausgerichtet. Vorzugsweise schließt die zweite Drehachse 14 einen rechten Winkel mit der ersten Drehachse 12 ein. Das hier beschriebene mikromechanische Bauteil ist jedoch nicht auf eine senkrechte Ausrichtung der beiden Drehachsen 12 und 14 zueinander beschränkt. Für den Fachmann sind anhand der nachfolgenden Beschreibungen auch Ausführungsformen des mikromechanischen Bauteils nahegelegt, bei welchen die beiden Drehachsen 12 und 14 einen Winkel zwischen 0° und 90° einschließen.

Die Spiegelplatte 10 ist über mindestens eine Innenfeder 16 mit einem Innenrahmen 18 verbunden. Der Innenrahmen 18 kann auch als Kardan-Rahmen bezeichnet werden. Beispielsweise ist der Innenrahmen 18 als Kardan-Ring ausgebildet. Die mindestens eine Innenfeder 16 kann eine entlang der ersten Drehachse 12 ausgerichtete Torsionsfeder sein. Zur Verbesserung der Stabilität kann die Spiegelplatte 10 über zwei an entgegen gerichteten Seiten angeordnete Innenfedern 16 mit dem Innenrahmen 18 verbunden sein.

An dem Innenrahmen 18 ist mindestens eine innere Aktor-Elektrodenkomponente 26 mit einem ersten Steg 50, an welchem Elektrodenfinger 26a und 26b angeordnet sind, befestigt. Der erste Steg 50 ist entlang der zweiten Drehachse 14 ausgerichtet. Vorzugsweise weist das mikromechanische Bauteil zwei derartige innere Aktor-Elektrodenkomponenten 26 auf, welche auf gegenüber liegenden Seiten von der ersten Drehachse 12 angeordnet sind. Jede der beiden Aktor-Elektrodenkomponenten 26 kann in diesem Fall an jeweils einem zugeordneten ersten Steg 50 ausgebildet sein. Vorzugsweise umfasst jede der beiden inneren Aktor-Elektrodenkomponenten 26 mehreren Elektrodenfinger 26a und 26b, welche beidseitig von der zweiten Drehachse 14 angeordnet sind und sich senkrecht zu der zweiten Drehachse 14 weg erstrecken.

Benachbart zu jeder inneren Aktor-Elektrodenkomponente 26 ist eine zugeordnete innere Stator-Elektrodenkomponente 30 fest an der Halterung angeordnet. Jede der inneren Stator-Elektrodenkomponenten 30 weist Elektrodenfinger 30a und 30b auf, welche den Elektrodenfingern 26a und 26b der benachbarten inneren Aktor-Elektrodenkomponente 26 zugeordnet sind. Die Ausrichtung der Elektrodenfinger 30a und 30b der inneren Stator-Elektrodenkomponenten 30 ist an die Elektrodenfinger 26a und 26b der benachbarten inneren Aktor-Elektrodenkomponente 26 angepasst.

Die Elektrodenfinger 26a, 26b, 30a und 30b der inneren Elektrodenkomponenten 26 und 30 können eine konstante Länge aufweisen. Die inneren Elektrodenkomponenten 26 und 30 der hier beschriebenen Ausführungsform mit einer konstanten Länge der Elektrodenfinger 26a, 26b, 30a und 30b weisen gegenüber Elektrodenkomponenten, deren Längen der Elektrodenfinger mit zunehmenden Abstand von dem Innenrahmen 18 abnehmen, den Vorteil eines größeren realisierbaren Drehmoments auf. Dieses größere realisierbare Drehmoment ist gewährleistet, da ein Austauchen der Elektrodenfinger 26a und 26b verhindert ist. Auf die Funktion der inneren Elektrodenkomponenten 26 und 30 wird unten noch genauer eingegangen.

Jedes von der Spiegelplatte 10 weggerichtete Ende eines ersten Stegs 50 ist über eine Zwischenfeder 52 mit einer äußeren Aktor-Elektrodenkomponente 24 verbunden. Die zwischen einem ersten Steg 50 und einer äußeren Aktor-Elektrodenkomponente 24 ausgebildete Zwischenfeder 52 ist entlang der zweiten Drehachse 14, d.h. entlang einer Längsachse des ersten Stegs 50, ausgerichtet. Die äußere Aktor-Elektrodenkomponente 24 als kann als Kammelektrode mit einem zweiten Steg 54 und an dem zweiten Steg 54 angeordneten Elektrodenfingern 24a ausgebildet sein. Weitere Ausbildungsmöglichkeiten für die äußere Aktor-Elektrodenkomponente 24 werden unten noch beschrieben.

Die äußere Aktor-Elektrodenkomponente ist über mindestens eine Außenfeder mit der (nicht dargestellten) Halterung verbunden. Bei der dargestellten Ausführungsform ist jede äußere Aktor-Elektrodenkomponente 24 über zwei als mäanderförmige Wippfedern 53 ausgebildete Außenfedern mit der Halterung verbunden. Dabei verlaufen die Längsrichtungen der mäanderförmigen Wippfedern 53 entlang einer Längsachse des zweiten Stegs 54 der äußeren Aktor-Elektrodenkomponente 24 und parallel zu der ersten Drehachse 12.

Die mindestens eine Zwischenfeder 52 weist bezüglich einer Torsion der Zwischenfeder 52 um die zweite Drehachse 14 eine vergleichsweise kleine erste Federsteifigkeit auf. Demgegenüber ist die mindestens eine Außenfeder, über welche eine äußere Aktor-Elektrodenkomponente 24 mit der Halterung verbunden ist, so ausgebildet, dass eine zweite Federsteifigkeit der mindestens einen Außenfeder, welche einer Drehbewegung der äußeren Aktor-Elektrodenkomponente um die zweite Drehachse 14 entgegenwirkt, größer als die erste Federsteifigkeit der Zwischenfeder 52 ist. Eine vorteilhaft große zweite (virtuelle) Federsteifigkeit ist beispielweise über beiden mäanderförmigen Wippfedern 53 realisierbar.

Während somit bereits mittels einer vergleichsweise kleinen Kraft eine Torsion der Zwischenfeder 52 um die zweite Drehachse 14 ausführbar ist, ist verhältnismäßig viel Kraft notwendig, um eine Drehbewegung der äußeren AktorElektrodenkomponente 24 um die zweite Drehachse 14 zu bewirken.

Auf diese Weise ist sichergestellt, dass bei einer Drehbewegung einer inneren Aktor-Elektrodenkomponente 26 um die zweite Drehachse 14 die benachbarte äußere Aktor-Elektrodenkomponente 24 nicht mitbewegt wird. Man kann dies als eine Entkoppelung der äußeren Aktor-Elektrodenkomponente 24 von der Drehbewegung der benachbarten inneren Aktor-Elektrodenkomponente 26 um die zweite Drehachse 14 bezeichnen. Durch eine derartige Entkoppelung ist das beim Stand der Technik auftretende unvorteilhafte Übersprechen bei dem hier beschriebenen mikromechanischen Bauteil verlässlich unterbunden.

Bevorzugterweise ist der zweite Steg 54 der mindestens einen äußeren Aktor-Elektrodenkomponente 24 nicht-parallel zu dem ersten Steg 50 der benachbarten inneren Aktor-Elektrodenkomponente 26, welcher entlang der zweiten Drehachse 14 verläuft, ausgerichtet. In diesem Fall können die Stege 50 und 54 gegenüber dem Stand der Technik länger ausgebildet werden, ohne dass die Ausdehnung des mikromechanischen Bauteils entlang der ersten Drehachse 12 und/oder der zweiten Drehachse 14 gesteigert wird. Somit ist unter Beibehaltung einer bevorzugten Größe des mikromechanischen Bauteils eine größere Anzahl von Elektrodenfingern 26a und 26b an dem mindestens einen ersten Steg 50 und/oder eine größere Anzahl von Elektrodenfingern 24a an dem mindestens einen zweiten Steg 54 anordbar. Dies führt zu einer Steigerung der realisierbaren Drehmomente zum Verstellen der Spiegelplatte 10 um die erste Drehachse 12 und/oder um die zweite Drehachse 14. Der zweite Steg 54 kann insbesondere senkrecht zu dem ersten Steg 50 ausgerichtet sein.

Aufgrund der relativ hohen realisierbaren Drehmomente können die Federn 16, 52 und 53 vergleichsweise steif ausgelegt werden. Dies gewährleistet eine vorteilhafte Robustheit des mikromechanischen Bauteils. Zusätzlich erleichtert dies das Herstellen der Federn 16, 52 und 53. Des Weiteren können die Federsteifigkeiten der Federn 16, 52 und 53 so festgelegt werden, dass auf die oben beschriebene Weise das unerwünschte Übersprechen unterbunden wird.

Die senkrecht zu dem zweiten Steg 54 ausgebildeten Elektrodenfinger 24a der mindestens einen äußeren Aktor-Elektrodenkomponente 24 weisen einen vergleichsweise großen Abstand zu der ersten Drehachse auf, was zusätzlich ein relativ hohes Drehmoment zum Verstellen der Spiegelplatte 10 um die erste Drehachse 12 gewährleistet. Deshalb kann die Anzahl der Elektrodenfinger 24a und 28a der äußeren Elektrodenkomponenten 24 und 28 reduziert werden, um ausreichend Anbringfläche für die Elektrodenfinger 26a, 26b, 30a und 30b der inneren Elektrodenkomponenten 26 und 30 zu gewährleisten. Auf diese Weise kann die Antriebskraft zum Verstellen der Spiegelplatte 10 um die zweite Drehachse 14 zusätzlich gesteigert werden.

Jeder der äußeren Aktor-Elektrodenkomponenten 24 ist eine äußere Stator-Elektrodenkomponente 28, welche an der Halterung befestigt ist, zugeordnet. Jede der äußeren Stator-Elektrodenkomponenten 28 umfasst Elektrodenfinger 28a, deren Ausrichtung und Lage zu den Elektrodenfingern 24a der zugeordneten äußeren Aktor-Elektrodenkomponente 24 korrespondieren.

Die äußeren Elektrodenkomponenten 24 und 28 sind so kontaktierbar, dass zwischen den Elektrodenfingern 24a und 28a auf einer ersten Seite der ersten Drehachse 12 eine erste Spannung ungleich Null anlegbar ist, wobei gleichzeitig gewährleistet ist, dass zwischen den Elektrodenfingern 24a und 28a auf der zweiten Seite der ersten Drehachse 12 keine Spannung anliegt. Ebenso kann zwischen den Elektrodenfingern 24a und 28a auf der zweiten Seite der ersten Drehachse 12 eine erste Spannung ungleich Null angelegt werden, ohne dass zwischen den Elektrodenfingern 24a und 28a auf der ersten Seite eine Spannung anliegt.

Des Weiteren sind die inneren Elektrodenkomponenten 26 und 30 so kontaktierbar, dass zwischen den auf der ersten Seite der zweiten Drehachse 14 angeordneten Elektrodenfingern 26a und 30a eine zweite Spannung ungleich Null anlegbar ist, während zwischen den auf der zweiten Seite der zweiten Drehachse 14 angeordneten Elektrodenfingern 26b und 30b keine Spannung anliegt. Zusätzlich kann die zweite Spannung auch zwischen den auf der zweiten Seite der zweiten Drehachse 14 angeordneten Elektrodenfingern 26b und 30b angelegt werden, während die zwischen den auf der ersten Seite der zweiten Drehachse 14 angeordneten Elektrodenfingern 26a und 30a anliegende Spannung gleich Null ist.

Die Ausbildung von geeigneten Kontaktelementen (z.B. Leitungen) und einer (nicht dargestellten) Steuereinrichtung zum Anlegen der ersten Spannung und der zweiten Spannung sind für einen Fachmann anhand der Fig. 3 nahegelegt. Es wird deshalb auf eine genauere Beschreibung dieser Komponenten verzichtet.

Im spannungslosen Zustand, d.h. sofern zwischen keiner der Elektrodenkomponenten 24, 26, 28, 30 eine Spannung anliegt, befinden sich die Aktor-Elektrodenkomponenten 24 und 26 und die Spiegelplatte 10 in einer Ausgangsstellung, welche vorzugsweise in einer gemeinsamen Ausgangsebene liegt. Die Elektrodenfinger 28a, 30a und/oder 30b einer Stator-Elektrodenkomponente 28 und/oder 30 können an einer von der Halterung weg gerichteten Seite der Ausgangsebene angeordnet sein. Ebenso können die Elektrodenfinger 28a, 30a und/oder 30b einer Stator-Elektrodenkomponente 28 und/oder 30 in einer Ebene zwischen der Ausgangsebene und der Halterung angeordnet sein.

Vorzugsweise erfolgt das Verstellen der Spiegelplatte 10 um die erste Drehachse 12 resonant. In diesem Fall ist die Steuereinrichtung dazu ausgelegt, als erste Spannung ein Spannungssignal bereitzustellen, welches eine Frequenz gleich einer Eigenfrequenz einer Schwingbewegung der Spiegelplatte 10 in Bezug auf den Innenrahmen 18 unter einem Biegen der mindestens einen Innenfeder 16 aufweist. Auf diese Weise kann bei geeignet festgelegten Werten der Masse der Spiegelplatte 10 und der Federsteifigkeit der mindestens einen Innenfeder 16 gezielt eine resonante Schwingbewegung der Spiegelplatte 10 um die erste Achse 12 in Bezug auf den Innenrahmen 18 unter einem Biegen der mindestens einen Innenfeder 16 angeregt werden. Dies bewirkt eine Steigerung des Spiegelverstellwinkels. Beispielsweise kann auf diese Weise die Spiegelplatte 10 um einen Spiegelverstellwinkel von 12° in Bezug auf die Halterung um die erste Drehachse 12 verstellt werden, während die äußere Aktor-Elektrodenkomponente 24 lediglich um einen Drehwinkel << 1° gegenüber der Halterung um die erste Drehachse 12 gekippt wird. Vorzugsweise wird als erste Spannung ein Spannungssignal mit einer Frequenz von ca. 20 kHz bereitgestellt.

Mit dem in Fig. 3 dargestellten mikromechanischen Bauteil ist eine Bildprojektion realisierbar. Vorzugsweise erfolgt die Bildprojektion durch ein Erstellen eines zeilenförmigen Bildaufbaus. Bei einer bevorzugten Ansteuerung des mikromechanischen Bauteiles werden die Spannungen so angelegt, dass die Spiegelplatte 10 in eine erste Schwingbewegung um die erste Drehachse 12 mit einer Frequenz von 20 kHz versetzt wird. Gleichzeitig wird die Spiegelplatte 10 in eine zweite quasi-statische Bewegung um die zweite Drehachse 14 mit einer Frequenz von 60 Hz versetzt. Man bezeichnet die zweite quasi-statische Bewegung der Spiegelplatte 10 häufig auch als sägezahnförmige quasi-statische Bewegung. Das mikromechanische Bauteil erfüllt in diesem Fall gut die Funktion eines Mikroscanners.

Im Vergleich zu dem herkömmlichen Mikrospiegel, welcher ein Zwei-Feder-Zwei Masse-System ist, ist das in den oberen Absätzen beschriebene mikromechanische Bauteil als Vier-Federn-Vier-Massen-System ausgebildet.

Bei einer bevorzugten Ausführungsform des dargestellten mikromechanischen Bauteils wird der gesamte Antriebsstrang, d.h. die mindestens eine äußere Aktor-Elektrodenkomponente 24 und die mindestens eine innere Aktor-Elektrodenkomponente 26, auf Masse gelegt. In diesem Fall ist es nicht notwendig, höhere Spannungen über die mindestens eine Außenfeder und die mindestens eine Zwischenfeder 52 zu führen. Deshalb müssen die Leitungen, welche über die Federn 52 und 53 geführt werden, nicht so ausgeführt werden, dass sie hohen Spannungen standhalten. Auf diese Weise ist gewährleistet, dass die Federsteifigkeiten der Federn 52 und 53 nicht durch Leitungen, welche speziell zum Anlegen von hohen Spannungen ausgebildet sind, beeinflusst werden.

Die hohen Potenziale zum Bereitstellen der ersten Spannung und der zweiten Spannung werden von außen an die Stator-Elektrodenkomponenten 28 und 30 angelegt. Dies ist mit einem vergleichsweise kleinen Aufwand realisierbar. Insbesondere können dabei die zum Anlegen der hohen Potenziale verwendeten Leitungen kostengünstig und auf einfache Weise hergestellt werden.

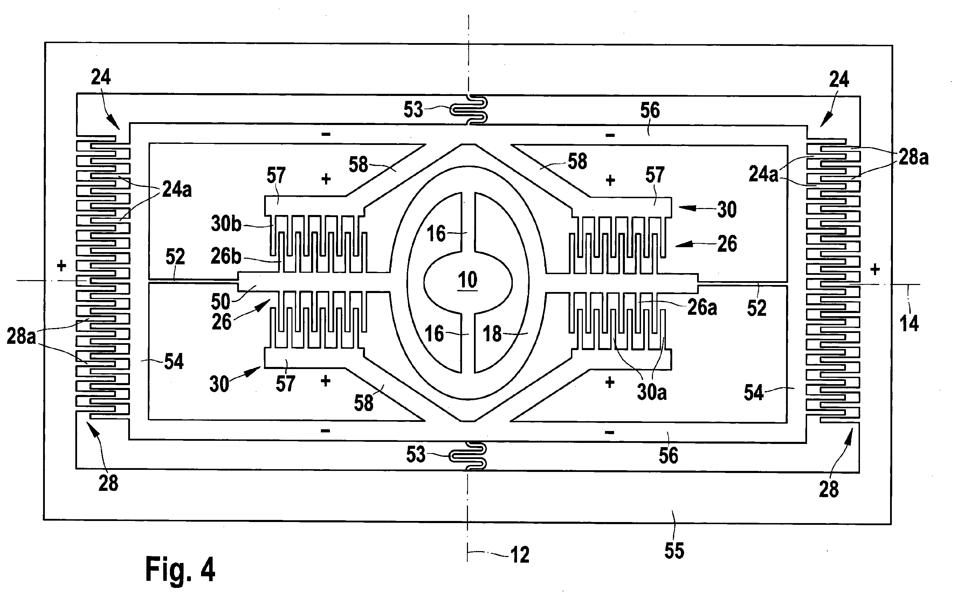

Fig. 4 zeigt eine schematische Darstellung einer zweiten Ausführungsform des mikromechanischen Bauteils.

Bei der dargestellten Ausführungsform sind als Ergänzung zu der vorhergehend beschriebenen Ausführungsform der Fig. 3 die zweiten Stege 54 der äußeren Aktor-Elektrodenkomponenten 24 über zwei Verbindungsstege 56 miteinander verbunden. Jeder der beiden Verbindungsstege 56 verbindet zwei auf einer Seite von der zweiten Drehachse 14 weggerichtete Enden der zweiten Stege 54 miteinander. Auf diese Weise bilden die zweiten Stege 54 und die Verbindungsstege 56 einen Zwischenrahmen. Vorzugsweise ist der Zwischenrahmen aus den Komponenten 54 und 56 rechteckig ausgebildet.

Der Zwischenrahmen aus den Komponenten 54 und 56 ist über zwei als mäanderförmige Wippfedern 53 ausgebildete Außenfedern mit der Halterung verbunden. Die beiden Längsachsen der mäanderförmigen Wippfedern 53 liegen auf der ersten Drehachse 12. Die Halterung kann beispielsweise als Außenrahmen 55 ausgebildet sein. Vorzugsweise sind in diesem Fall die Elektrodenfinger 28 der äußeren Stator-Elektrodenkomponenten 28 an parallel zu den zweiten Stegen 54 ausgerichteten Innenflächen des Außenrahmens 55 befestigt. Das mikromechanische Bauteil ist jedoch nicht auf eine derartige Ausbildung der Halterung beschränkt.

Während die beiden äußeren Stator-Elektrodenkomponenten 28 somit fest an der Halterung angeordnet sind, sind die inneren Stator-Elektrodenkomponenten 30 an dem Zwischenrahmen aus den Komponenten 54 und 56 befestigt. Somit werden die inneren Stator-Elektrodenkomponenten 30 mit dem Zwischenrahmen durch die äußeren Elektrodenkomponenten 24 und 28 aktuiert. Zum Befestigen der inneren Stator-Elektrodenkomponenten 30 an dem Zwischenrahmen können die Stege 57 der als Kammelektroden ausgebildeten innen Stator-Elektrodenkomponenten 30 mittels je eines Befestigungsstegs 58 mit dem benachbarten Verbindungssteg 56 verbunden werden.

Die an die Elektrodenfinger 30a und 30b der inneren Stator-Elektrodenkomponenten 30 angelegte Spannung wird über die mäanderförmigen Wippfedern 53 geführt. Zusätzlich wird auch das Massepotenzial, welches an die Elektrodenfinger 24a, 26a und 26b der Aktor-Elektrodenkomponenten 24 und 26 angelegt wird, über die mäanderförmigen Wippfedern 53 geführt. Vorzugsweise werden das Massepotenzial über eine erste mäanderförmige Wippfedern 53 und das Hochspannungssignal über eine zweite mäanderförmige Wippfedern 53 geführt. Die Leitungen zum Anlegen eines hohen Potenzials an die Elektrodenfinger 30a oder 30b der inneren Stator-Elektrodenkomponenten 30 können auch über die Komponenten 57 und 58 geführt werden.

Anstelle der mäanderförmigen Wippfedern 53 können auch V-Federn eingesetzt werden. Die Potentiale können in diesem Fall über die V-Federn geführt werden. Über eine V-Feder können dabei zwei Leitungen geführt werden. Insgesamt können somit über zwei V-Federn 4 Leitungen geführt werden. Dies kann zum Ansteuern und Auslesen von Sensierelementen von Vorteil sein.

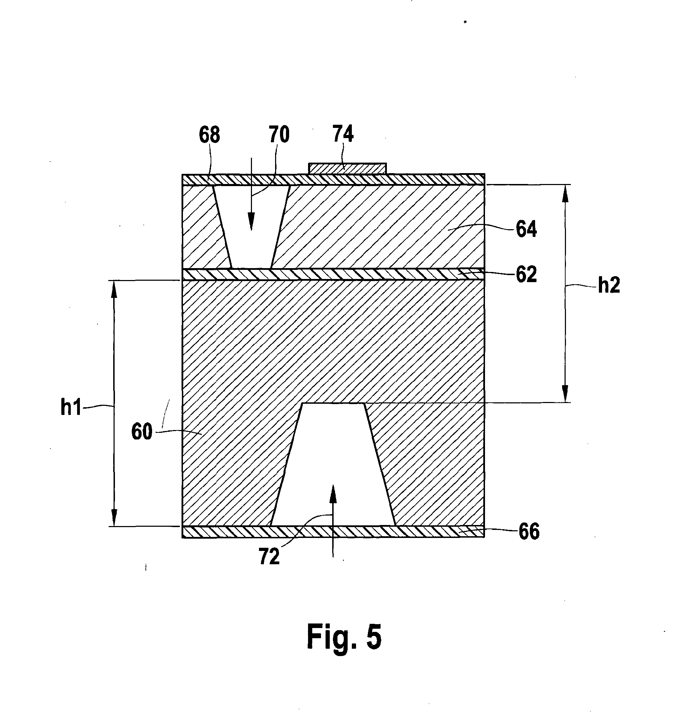

Fig. 5 zeigt einen Querschnitt durch einen Schichtaufbau zum Darstellen einer Ausführungsform des Herstellungsverfahrens.

Mittels des nur teilweise beschriebenen Herstellungsverfahrens kann beispielsweise das in Fig. 4 dargestellte mikromechanische Bauteil hergestellt werden. Die zum Herstellen des mikromechanischen Bauteils der Fig. 4 ausgeführten Verfahrensschritte sind für einen Fachmann anhand des im Weiteren beschriebenen Schichtaufbaus nahegelegt.

Der Schichtaufbau umfasst eine erste Halbleiterschicht 60, eine die erste Halbleiterschicht 60 zumindest teilweise abdeckende Isolierschicht 62 und eine die Isolierschicht 62 abdeckende zweite Halbleiterschicht 64. In der Isolierschicht 62 können Aussparungen ausgebildet sein, welche Bereiche der Halbleiterschichten 60 und 64 einstückig miteinander verbinden. Die erste Halbleiterschicht 60 ist beispielsweise ein Siliziumsubstrat. Die auch als vergrabene Oxidschicht (Burried Oxid Layer) bezeichenbare Isolierschicht 62 kann ein Oxid und/oder ein anderes isolierendes Material umfassen. Die zweite Halbleiterschicht 64 kann insbesondere eine SOI-Schicht (Silicon On Isolator) sein.

Eine der Isolierschicht 62 entgegen ausgerichtete Rückseite der ersten Halbleiterschicht 60 wird zumindest teilweise von einer Rückseitenschicht 66, vorzugsweise aus einem Oxid, abgedeckt. Entsprechend wird eine äußere Oberfläche der zweiten Halbleiterschicht 64 zumindest teilweise von einer Oberseitenschicht 68 abgedeckt, welche ebenfalls ein Oxid enthalten kann.

Mittels der dem Fachmann bekannten Verfahren, beispielsweise einem lithographischen Verfahren, können durchgehende Aussparungen in den Schichten 66 und 68 ausgebildet werden. Somit ist es möglich, über einen Vorderseiten-Trench erste Aussparungen 70 in die zweite Halbleiterschicht 64 und über einen Rückseiten-Trench zweite Aussparungen 72 in die erste Halbleiterschicht 60 zu ätzen. Auf diese Weise können Komponenten 10 bis 30 und 50 bis 58 des mikromechanischen Bauteils der Fig. 4 aus dem dargestellten Schichtaufbau herausstrukturiert werden. Geeignete Ätzverfahren, wie beispielsweise ein KOH-Ätzen, sind für den Fachmann anhand der Fig. 5 nahegelegt.

Die Halterung ist beispielsweise aus dem Material der ersten Halbleiterschicht mit einer Höhe h1 gleich der Schichtdicke der ersten Halbleiterschicht 60 geformt. Die Stege 50, 54 bis 58 und die Spiegelplatte 10 können durch das Ätzen der Aussparungen 70 und 72 mit einer Höhe h2 aus Bereichen der Halbleiterschichten 60 und 64 und der Isolierschicht 62 gebildet werden. Vorzugsweise sind die Federn 16, 52 und 53 ausschließlich aus Bereichen der zweiten Halbleiterschicht 64, deren Schichtdicke kleiner als die Schichtdicke der ersten Halbleiterschicht 60 ist, herausstrukturiert. Dies gewährleistet vorteilhafte Werte für die Federsteifigkeiten der Federn 16, 52 und 53.

Da das Herausstrukturieren der Aktor-Elektrodenfinger 24a, 26a und 26b in einer Lage Out-Of-Plane in Bezug auf die Stator-Elektrodenfinger 28a, 30a und 30b für den Fachmann anhand der Figuren 4 und 5 nahegelegt ist, wird darauf nicht eingegangen.

Über ein Ausbilden von mindestens einer Metallschicht 74 auf der Oberseitenschicht 68, vorzugsweise auf Aluminium, können Leitungen zum Anlegen von Potenzialen an die Elektrodenfinger 24a, 26a, 26b, 28a, 30a und 30b auf einfache Weise und kostengünstig hergestellt werden.

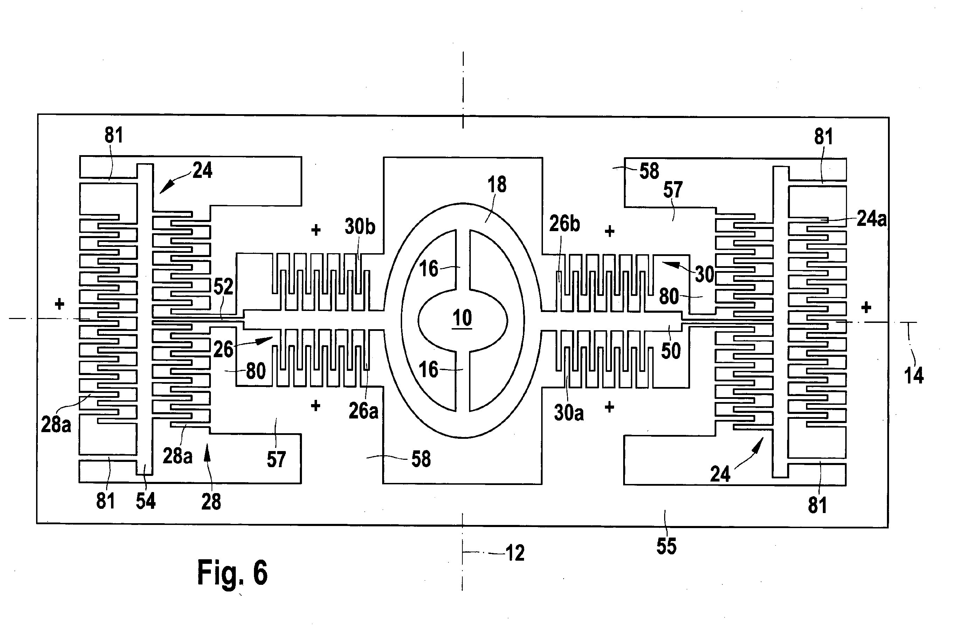

Fig. 6 zeigt eine schematische Darstellung einer dritten Ausführungsform des mikromechanischen Bauteils.

Bei der dargestellten Ausführungsform sind die Elektrodenfinger 30a und 30b der inneren Stator-Elektrodenkomponenten über die Stege 57 und 58 an der als Außenrahmen 55 ausgebildeten Halterung befestigt. Dies erlaubt eine robustere Ausbildung der Stege 57 und 58 und erleichtert das Anbringen von Leitungen, welche die Elektrodenfinger 30a und 30b der inneren Stator-Elektrodenkomponente mit einer Spannungsquelle verbinden.

Die anhand der Fig. 6 dargestellte Ausführungsform weist außerdem den Vorteil auf, dass eine vergleichsweise geringe Masse über die durch die Elektrodenkomponenten 24 bis 30 bewirkten Drehmomente verstellt wird. Somit bewirken bereits vergleichsweise kleine Spannungen an den Elektrodenkomponenten 24 bis 30 die gewünschte Auslenkung der Spiegelplatte 10.

Zusätzlich können an den Stegen 57 der inneren Stator-Elektrodenkomponente Zusatzstege 80 befestigt werde, welche parallel zu den zweiten Stegen 54 der äußeren Aktor-Elektrodenkomponente 24 ausgerichtet sind. An den Zusatzstegen 80 können weitere Elektrodenfinger 28a der äußeren Stator-Elektrodenkomponente 28 ausgebildet werden. In diesem Fall sind die Elektrodenfinger24a bevorzugt beidseitig an dem zweiten Steg 54 der äußeren Aktor-Elektrodenkomponente 24 ausgebildet. Auf diese Weise ist die Anzahl der Elektrodenfinger 24a und 28a der äußeren Elektrodenkomponenten 24 und 28 steigerbar und ein größeres Drehmoment zum Verstellen der Spiegelplatte 10 um die erste Drehachse 12 realisierbar. Durch die kompakte Ausbildung der Stege 57 und 58 ist eine ausreichende Anbringfläche für Leitungen zum Anlegen eines Potenzials an die an den Zusatzstegen 80 ausgebildeten Elektrodenfinger 28a gewährleistet.

Im Gegensatz zu der vorhergehend beschriebenen Ausführungsform der Fig. 4 sind die Außenfedern als stegförmige Biegefedern 81, welche parallel zu der zweiten Drehachse 14 ausgerichtet sind, ausgebildet. Je eine Biegefeder 81 verbindet ein Ende eines zweiten Stegs 54 der äußeren Aktor-Elektrodenkomponenten 24 mit einer benachbarten, parallel zu dem zweiten Steg 54 ausgerichteten Innenfläche des Außenrahmens 55. Auf die Eigenschaften einer derartigen Außenfeder wird unten noch genauer eingegangen. Anstelle mindestens einer Biegefeder 81 kann auch mindestens eine Mäanderfeder verwendet werden.

Die Ausdehnung des mikromechanischen Bauteils entlang der ersten Drehachse 12 ist vergleichsweise klein, da ein Zwischenrahmen nicht erforderlich ist und die Biegefedern 81 nicht entlang der ersten Drehachse 12 ausgerichtet sind.

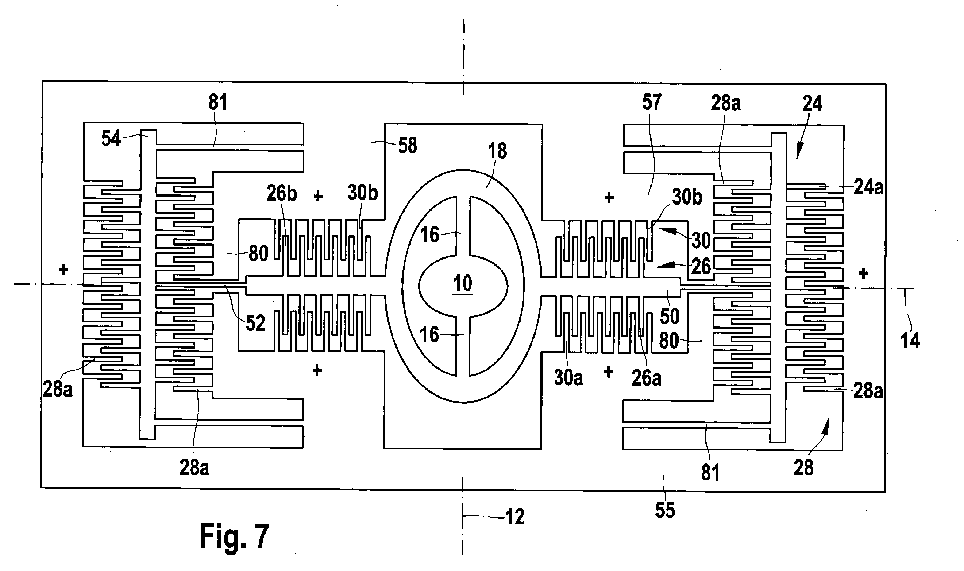

Fig. 7 zeigt eine schematische Darstellung einer vierten Ausführungsform des mikromechanischen Bauteils.

Im Unterschied zu der vorhergehend beschriebenen Ausführungsform sind bei dem in Fig. 7 dargestellten mikromechanischen Bauteil die Außenfedern als stegförmige Biegefedern 81, welche ein Ende eines zweiten Stegs 54 einer äußeren Aktor-Elektrodenkomponente 24 mit einem Verbindungssteg 58 verbinden, ausgebildet. Man kann dies auch als ein Verstreben der Außenfedern/der Biegefedern 81 nach innen bezeichnen. Bei einer derartigen Anordnung der Biegefedern 81 können die Längen der Außenfedern gesteigert werden, ohne dass eine Ausdehnung des dargestellten mikromechanischen Bauteils entlang der zweiten Drehachse 14 verlängert wird. Durch die längere Ausbildung der Biegefedern 81 kann die Federsteifigkeit der Biegefedern 81 bei gleicher Breite reduziert werden. Dies gewährleistet eine bessere Verstellbarkeit der äußeren Aktor-Elektrodenkomponenten 24 um die erste Drehachse 12.

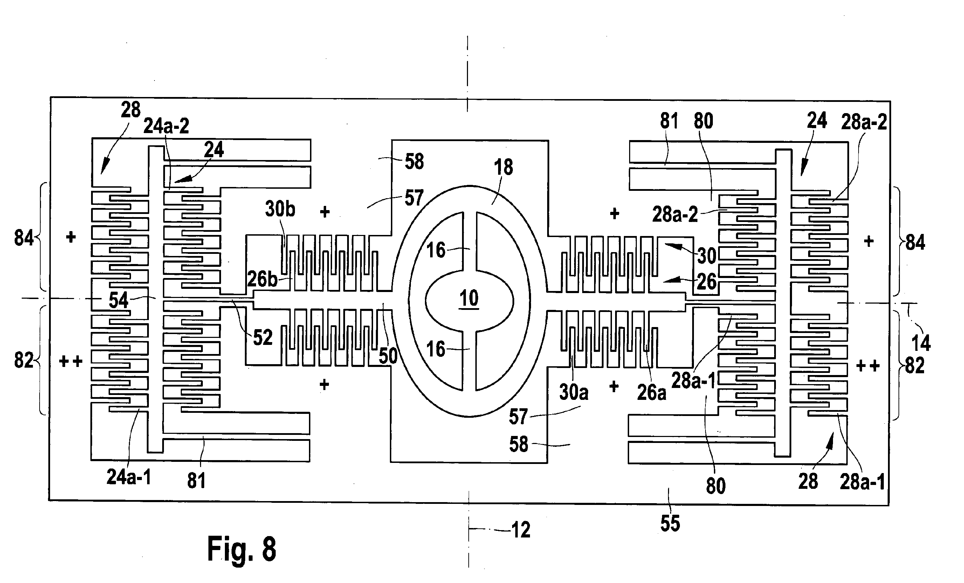

Fig. 8 zeigt eine schematische Darstellung einer fünften Ausführungsform des mikromechanischen Bauteils.

Bei dem dargestellten mikromechanischen Bauteil sind die auf einer Seite der ersten Drehachse 12 zusammenwirkenden äußeren Elektrodenkomponenten 24 und 28 so ausgebildet, dass zwischen den auf der ersten Seite der zweiten Drehachse 14 angeordneten Elektrodenfingern 24a-1 und 28a-1 der zusammenwirkenden äußerer Elektrodenkomponenten 24 und 28 als erste Spannung ein erster Spannungswert anlegbar ist und zwischen den auf der zweiten Seite der zweiten Drehachse 14 angeordneten Elektrodenfingern 24a-2 und 28a-2 der zusammenwirkenden äußeren Elektrodenkomponenten 24 und 28 ein von dem ersten Spannungswert abweichender zweiter Spannungswert als erste Spannung anlegbar ist. Man kann dies auch so bezeichnen, dass die als Elektrodenflächen fungierenden Elektrodenfinger 24a oder 28a mindestens einer der zusammenwirkenden äußerer Elektrodenkomponenten 24 und 28 von der zweiten Drehachse 14 in auf einer ersten Seite der zweiten Drehachse 14 angeordnete erste Elektrodenflächen 24a-1 oder 28a-1 und auf einer zweiten Seite der zweiten Drehachse angeordnete zweite Elektrodenflächen 24a-2 oder 28a-2 unterteilt werden, wobei die ersten Elektrodenflächen 24a-1 oder 28a-1 an mindestens eine (nicht dargestellte) erste Leitung so gekoppelt sind, dass ein erstes Potential an die ersten Elektrodenflächen 24a-1 oder 28a-1 anlegbar ist, und die zweiten Elektrodenflächen 24a-2 oder 28a-2 an mindestens eine (nicht skizzierte) zweite Leitung so gekoppelt sind, dass ein von dem ersten Potential abweichendes zweites Potential an die zweiten Elektrodenflächen 24a-2 oder 28a-2 anlegbar ist. Bevorzugterweise umfasst das mikromechanische Bauteil eine Steuereinrichtung, welche dazu ausgelegt ist, das erste Potential an die ersten Elektrodenflächen 24a-1 oder 28a-1 und das zweite Potential an die zweiten Elektrodenflächen 24a-2 oder 28a-2 anzulegen.

Nachfolgend wird auf eine mögliche Ausführungsform eines derartigen mikromechanischen Bauteils genauer eingegangen:
Bei der dargestellten Ausführungsform ist jede äußere Stator-Elektrodenkomponente 28 in eine erste Unterkomponente 82 und in eine zweite Unterkomponente 84 unterteilt. Die erste Unterkomponente 82 umfasst die Elektrodenfinger 28a-1 der zugehörigen äußeren Stator-Elektrodenkomponente 28, welche auf der ersten Seite der zweiten Drehachse 14 angeordnet sind. Die Elektrodenfinger 28a-1 der ersten Unterkomponente 82 können an einer parallel zu dem zweiten Steg 54 ausgerichteten Innenfläche des Außenrahmens 55 und/oder an einer Außenfläche des Zusatzstegs 80 angeordnet sein. Entsprechend sind die auf der zweiten Seite der zweiten Drehachse 14 angeordneten Elektrodenfinger 28a-2 der äußeren Stator-Elektrodenkomponente 28 der zweiten Unterkomponente 84 zugeordnet. Auch die Elektrodenfinger 28a-2 der zweiten Unterkomponente 84 können an dem Außenrahmen 55 und/oder an dem Zusatzsteg 80 befestigt sein.

An die Elektrodenfinger 28a-1 der ersten Unterkomponente 82 kann ein erstes Potential angelegt werden. Gleichzeitig kann ein von dem ersten Potential abweichendes zweites Potential an die Elektrodenfinger 28a-2 der zweiten Unterkomponente 84 angelegt werden. Die zum Kontaktieren der Elektrodenfinger 28a-1 und 28a-2 verwendbaren Leitungen der beiden Unterkomponenten 82 und 84 der äußeren Stator-Elektrodenkomponente 28 sind für den Fachmann anhand Figur 8 nahegelegt. Es wird deshalb nicht genauer darauf eingegangen.

Die Unterteilung der mindestens einen äußeren Stator-Elektrodenkomponente 28 in die Unterkomponenten 82 und 84 führt zu dem Vorteil, dass an der, beispielsweise als Außenrahmen 55 ausgebildeten Halterung genügend Anbringfläche zum Bilden der Leitungen der Unterkomponenten 82 und 84 vorhanden ist. Des Weiteren wird auch durch die kompakte Ausbildung der Stege 57 und 58 das Bilden der Leitungen der Unterkomponenten 82 und 84 erleichtert.

Es wird jedoch darauf hingewiesen, dass das mikromechanische Bauteil nicht auf eine Unterteilung mindestens einer äußeren Stator-Elektrodenkomponente 28 in die Unterkomponenten 82 und 84 bezüglich der zweiten Drehachse 14 beschränkt ist. Anstelle oder als Ergänzung zu der mindestens einen unterteilten äußeren Stator-Elektrodenkomponente 28 kann auch mindestens eine äußere Aktor-Elektrodenkomponente 24 so unterteilt werden, dass an die auf den beiden Seiten der zweiten Drehachse 14 angeordneten Elektrodenfinger 24a-1 und 24a-2 unterschiedliche Potentiale anlegbar sind. Da eine derartige Ausbildung des mikromechanischen Bauteils für den Fachmann anhand von Figur 8 nahegelegt ist, wird nicht weiter darauf eingegangen.

Durch das Anlegen eines ersten Spannungswerts zwischen den auf der ersten Seite der zweiten Drehachse 14 angeordneten Elektrodenfingern 24a-1 und 28a-1 der zusammenwirkenden äußeren Elektrodenkomponenten 24 und 28 und das Anlegen des von ersten Spannungswert abweichenden zweiten Spannungswerts zwischen den auf der zweiten Seite der zweiten Drehachse 14 angeordneten Elektrodenfingern 24a-2 und 28a-2 der gleichen äußeren Elektrodenkomponenten 24 und 28 kann ein zusätzliches Drehmoment um die zweite Drehachse 14 auf die äußere Aktor-Elektrodenkomponente 24 ausgeübt werden. In einer bevorzugten Ausführungsform werden der erste Spannungswert und der zweite Spannungswert von der Steuereinrichtung so bereitgestellt, dass das zusätzliche Drehmoment auf die äußere Aktor-Elektrodenkomponente 24 um die zweite Drehachse 14 ein von der benachbarten inneren Aktor-Elektrodenkomponente 26 bewirktes Zusatz-Drehmoment bei einem Verstellen der inneren Aktor-Elektrodenkomponente 26 um die zweite Drehachse 14 kompensiert. Dies ist realisierbar, indem die Steuereinrichtung zusätzlich dazu ausgelegt wird, eine Differenz zwischen dem angelegten ersten Potential/dem ersten Spannungswert und dem zweiten Potential/dem zweiten Spannungswert unter Berücksichtigung einer Information bezüglich der zwischen dem mindestens einen Elektrodenfinger 26a oder 26b der inneren Aktor-Elektrodenkomponente 26 und der inneren Stator-Elektrodenkomponente 30 anliegenden zweiten Spannung und/oder einer aktuellen Stellung des mindestens einen Elektrodenfingers 26a oder 26b der inneren Aktor-Elektrodenkomponente 26 in Bezug auf die inneren Stator-Elektrodenkomponente 30 festzulegen.

Auf diese Weise ist das bei einem herkömmlichen mikromechanischen Bauteil auftretende Übersprechen aufgrund eines Mitbewegens der äußeren Aktor-Elektrodenkomponente 24 bei einem Verstellen der benachbarten inneren Aktor-Elektrodenkomponente 26 um die zweite Drehachse 14 verhinderbar. Die im Stand der Technik auftretende unerwünschte Kopplung zwischen den beiden Verstellbewegungen der Spiegelplatte 10 ist somit so unterbindbar, dass sie ein gewünschtes Verstellen der Spiegelplatte 10 nicht oder kaum beeinträchtigt.

Die Unterteilung mindestens einer äußeren Elektrodenkomponente 24 oder 28 in die beiden Unterkomponenten 82 und 84 und das Anlegen unterschiedlicher Spannungswerte zwischen den Elektrodenflächen 24a-1, 24a-2, 28a-1 und 28a-2 der zusammenwirkenden äußeren Elektrodenkomponenten 24 und 28 auf den beiden Seiten der zweiten Drehachse 14 kann auch als ein Betreiben des mikromechanischen Bauteils in einem Closed-Loop-Betrieb bezeichnet werden. Es wird noch einmal darauf hingewiesen, dass bei einem derartigen Closed-Loop-Betrieb zwei zusammenwirkende äußere Elektrodenkomponenten 24 und 28, welche so ausgebildet sind, dass über ein Anlegen der ersten Spannung an den Elektrodenfingern 24a-1, 24a-2, 28a-1 und 28a-2 die Spiegelplatte um die erste Drehachse 12 verstellbar ist, die Elektrodenfinger 24a-1, 24a-2, 28a-1 und 28a-2 so unterteilt sind, dass zwischen den auf der ersten Seite der zweiten Drehachse 14 angeordneten Elektrodenfingern 24a-1 und 28a-1 der erste Spannungswert und zwischen den auf der zweiten Seite der zweiten Drehachse 14 angeordneten Elektrodenfingern 24a-2 und 28a-2 der von dem ersten Spannungswert abweichende zweite Spannungswert anlegbar sind.

Auch die in den Figuren 4 und 6 dargestellten Ausführungsformen des mikromechanischen Bauteils können in einer Weiterbildung in dem Closed-Loop-Betrieb betrieben werden. Da für den Closed-Loop-Betrieb geeignete Weiterbildungen für den Fachmann durch die oberen Absätze nahegelegt sind, wird nicht genauer darauf eingegangen.

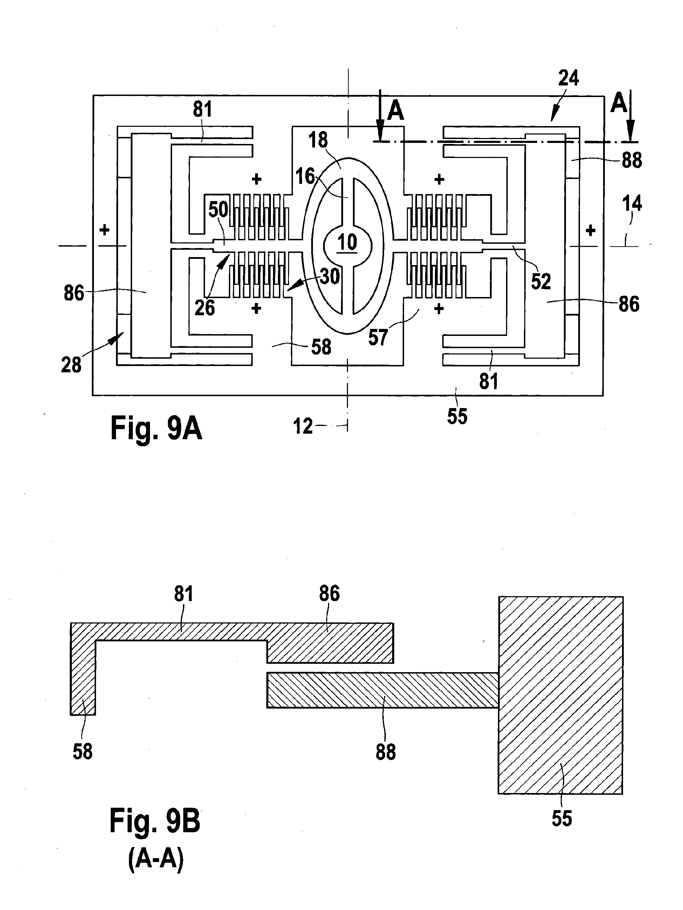

Fig. 9A und 9B zeigen schematische Darstellungen einer sechsten Ausführungsform des mikromechanischen Bauteils.

Die in Fig. 9A als Draufsicht gezeigte Ausführungsform weist anstelle eines äußeren elektrischen Kammantriebs einen äußeren elektrischen Plattenantrieb auf. Die äußere Aktor-Elektrodenkomponente 24 ist in diesem Fall als Aktor-Plattenelektrode 86 ausgebildet, welche über die entlang der zweiten Drehachse 14 verlaufende Zwischenfeder 52 mit dem ersten Steg 50 der benachbarten inneren Aktor-Elektrodenkomponente 26 verbunden ist. Vorzugsweise ist die Aktor-Plattenelektrode 86 in ihrer Ausgangsstellung (im spannungslosen Betrieb) parallel zu einer von den beiden Drehachsen 12 und 14 aufgespannten Ebene ausgerichtet. Die Aktor-Plattenelektrode 86 ist über mindestens eine Außenfeder direkt oder indirekt mit der Halterung verbunden. Die mindestens eine Außenfeder kann beispielsweise eine Biegefeder 81 umfassen. Bei der dargestellten Ausführungsform verlaufen zwei Biegefedern 81 zwischen der Aktor-Plattenelektrode 86 und einem benachbarten Verbindungssteg 58 parallel zu der zweiten Drehachse 14. Für den Fachmann sind anhand der hier gezeigten Figuren auch weitere mögliche Ausführungsbeispiele für die mindestens eine Außenfeder, welche die Aktor-Plattenelektrode 86 direkt oder indirekt mit der Halterung verbindet, nahegelegt.

Auch die äußere Stator-Elektrodenkomponente 28 kann als mindestens eine Stator-Plattenelektrode 88 ausgebildet sein. Wie anhand des in Figur 9B dargestellten Querschnitts durch die Figur 9A entlang der Linie A-A erkennbar ist, ist die mindestens eine Stator-Plattenelektrode 28 bevorzugterweise in einem minimalen Abstand parallel zu der Ausgangsstellung der Aktor-Plattenelektrode 86 ausgerichtet. Vorteilhafterweise können die Plattenelektroden 86 und 88 Überlappflächen aufweisen. Der Abstand zwischen den Überlappflächen kann nur wenige Mikrometer betragen. Dies gewährleistet ein relativ großes Drehmoment zum Verstellen der Spiegelplatte 10 um die erste Drehachse 12 durch Verwendung der Plattenelektroden 86 und 88.

In einer Weiterbildung der dargestellten Ausführungsform kann mindestens eine der zusammenwirkenden äußeren Elektrodenkomponenten 24 und 28 in Unterkomponenten unterteilt sein. In diesem Fall weist mindestens eine der äußeren Elektrodenkomponenten 24 und 28 eine erste Teil-Plattenelektrode auf der ersten Seite der zweiten Drehachse 14 und eine zweite Teil-Plattenelektrode auf der zweiten Seite der zweiten Drehachse 14 auf. Somit können zwischen den auf der ersten Seite der zweiten Drehachse 14 angeordneten ersten Elektrodenflächen der zusammenwirkenden äußeren Elektrodenkomponenten 24 und 28 ein erster Spannungswert und zwischen den auf der zweiten Seite der zweiten Drehachse 14 angeordneten zweiten Elektrodenflächen der zusammenwirkenden äußeren Elektrodenkomponenten 24 und 28 ein von dem ersten Spannungswert abweichender zweiter Spannungswert angelegt werden.

Auf diese Weise kann auch über die zusammenwirkenden äußeren Elektrodenkomponenten 24 und 28 des elektrischen Plattenantriebs ein zusätzliches Drehmoment auf die äußere Aktor-Elektrodenkomponente 24 ausgeübt werden, welches einem Mitbewegen der äußeren Aktor-Elektrodenkomponente 24 bei einem Verstellen der benachbarten inneren Aktor-Elektrodenkomponente 26 um die zweite Drehachse 14 entgegenwirkt. Eine derartige Weiterbildung des elektrischen Plattenantriebs und die zum Kontaktieren des Plattenantriebs benötigten Leitungen sind für den Fachmann anhand der hier gegebenen Beschreibung nahegelegt. Es wird deshalb nicht näher auf eine derartige Weiterbildung eingegangen.

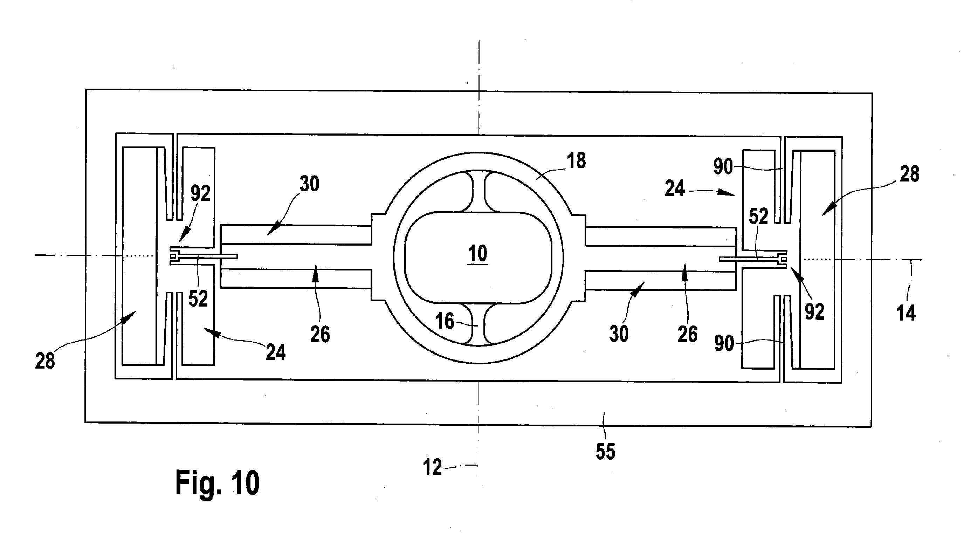

Figur 10 zeigt eine schematische Darstellung einer siebten Ausführungsform des mikromechanischen Bauteils.

Eine Möglichkeit zum Unterbinden des Übersprechens, das heißt des Mitbelegens der äußeren Aktor-Elektrodenkomponente 24 bei einem Verstellen der benachbarten inneren Aktor-Elektrodenkomponente 26 um die zweite Drehachse, besteht in einer geeigneten Ausbildung und Positionierung der mindestens einen Außenfeder, über welche die äußere Aktor-Elektrodenkomponente 24 mit der Halterung verbunden ist.

Vorzugsweise ist eine erste Federsteifigkeit der Zwischenfeder 52 bezüglich einer Torsion der Zwischenfeder 52 um die zweite Drehachse 14 kleiner als eine zweite Federsteifigkeit der mindestens einen Außenfeder, welche einer Drehbewegung der äußeren Aktor-Elektrodenkomponente 24 um die zweite Drehachse 14 entgegen wirkt. Dies ist auf einfache Weise realisierbar, indem die Außenfeder oder eine aus mehreren Außenfedern zusammengesetzte Federaufhängung so ausgebildet und angeordnet wird, dass eine erste Biegesteifigkeit der mindestens einen Außenfeder bezüglich einer ersten Verstellbewegung der äußeren Aktor-Elektrodenkomponente 24 entlang einer ersten Bewegungsrichtung senkrecht zu den beiden Drehachsen 12 und 14 relativ gering ist. Zusätzlich ist es vorteilhaft, wenn eine zweite Biegesteifigkeit der Außenfeder oder der Federaufhängung bezüglich einer zweiten Verstellbewegung der äußeren Aktor-Elektrodenkomponente 24 entlang einer zweiten Bewegungsrichtung, welche nicht-parallel zu der ersten Bewegungsrichtung ausgerichtet ist, vergleichsweise groß ist. Geeignete vorteilhafte Ausführungsbeispiele für die mindestens eine Außenfeder zum Gewährleisten der vorteilhaften ersten Biegesteifigkeit und zweiten Biegesteifigkeit sind in den vorhergehenden Figuren bereits dargestellt.

Bei dem in Figur 10 dargestellten mikromechanischen Bauteil ist jede äußere Aktor-Elektrodenkomponente 24 über zwei parallel zu der ersten Drehachse 12 ausgerichtete Torsionsfedern 90 mit der als Außenrahmen 55 ausgebildeten Halterung verbunden. Die Torsionsfedern 90 sind vorzugsweise stegförmig ausgebildet.

Über das Anordnen der äußeren Aktor-Elektrodenkomponente 24 an dem Außenrahmen 55 über die beiden Torsionsfedern 90 ist gewährleistet, dass sich die äußere Aktor-Elektrodenkomponente 24 mit einer vergleichsweise kleinen Kraft in die gewünschten ersten Verstellrichtung senkrecht zu den beiden Drehachsen 12 und 14 verstellen lässt. Demgegenüber ist eine vergleichsweise große Kraft notwendig, um die äußere Aktor-Elektrodenkomponente 24 in die zu der ersten Verstellrichtung nicht-parallele zweite Verstellrichtung zu bewegen. Man kann dies auch so bezeichnen, dass die beiden Torsionsfedern 90 für eine bevorzugte translatorische Bewegung (senkrecht zu den beiden Drehachsen 12 und 14) der äußeren Aktor-Elektrodenkomponente 24 ausgelegt sind. Die beiden Torsionsfedern 90 wirken in diesem Fall zusammen als eine zweiseitig eingespannte Biegefeder.

Des Weiteren kann eine Zwischenfeder 52 an einem zu der äußeren Aktor-Elektrodenkomponente benachbarten Endabschnitt eine durchgehende Aussparung aufweisen, welche den Endabschnitt in einen ersten Schenkel und in einen zweiten Schenkel unterteilt. Vorzugsweise ist der Endabschnitt so unterteilt, dass die beiden Schenkel und ein zwischen den beiden Schenkeln verlaufender Verbindungssteg eine U-förmige Federanbindung 92 bilden.

Wie der Fachmann erkennen kann, können die äußeren Elektrodenkomponenten 24 und 28 der dargestellten Ausführungsform und der im Weiteren beschriebenen Ausführungsformen als Kammantrieb und/oder als Plattenantrieb ausgebildet sein. Die Elektrodenflächen zum Anlegen eines Potentials mindestens einer äußeren Elektrodenkomponente 24 und 28 können zusätzlich bezüglich der zweiten Drehachse 14 unterteilt sein. Eine derartige Weiterbildung der Ausführungsformen ist durch die vorhergehenden Absätze nahegelegt.

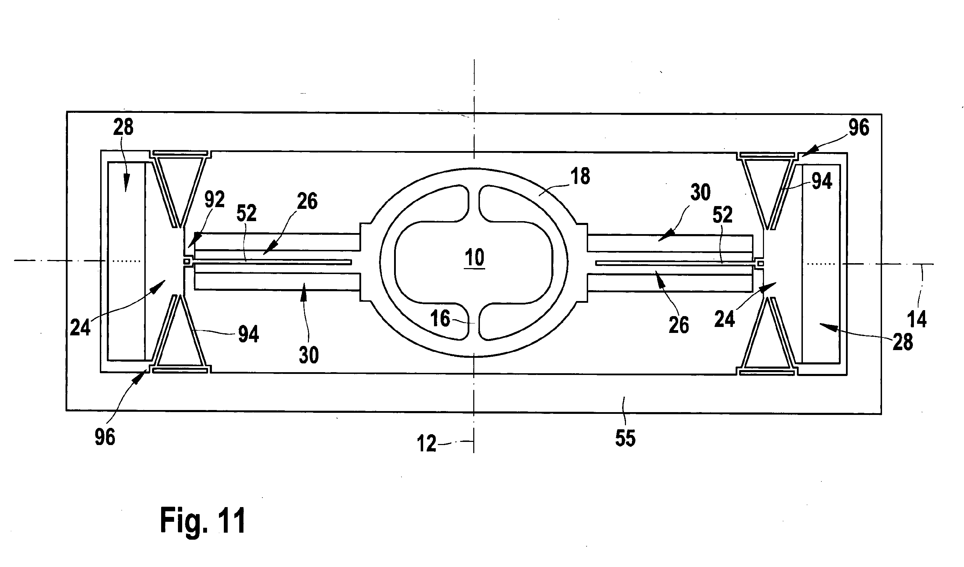

Figur 11 zeigt eine schematische Darstellung einer achten Ausführungsform des mikromechanischen Bauteils.

Jede äußere Aktor-Elektrodenkomponente 24 des dargestellten mikromechanischen Bauteils ist über zwei V-Federn 94 mit der als Außenrahmen 55 ausgebildeten Halterung verbunden. Vorzugsweise sind die V-Federn 94 so ausgebildet, dass ihre Symmetrieachsen parallel zu der ersten Drehachse 12 verlaufen. Auf diese Weise ist gewährleistet, dass die als X-förmige Federanordnung bezeichenbare Anordnung der zwei V-Federn 94 einer äußeren Aktor-Elektrodenkomponente 24 eine relativ kleine erste Biegesteifigkeit bezüglich der ersten Verstellbewegung der äußeren Aktor-Elektrodenkomponente 24 entlang der ersten Verstellrichtung senkrecht zu den beiden Drehachsen 12 und 14 hat. Demgegenüber ist die zweite Biegesteifigkeit der X-förmigen Federanordnung für eine zu der ersten Verstellrichtung nicht-parallel ausgerichtete zweite Verstellrichtung vergleichsweise groß. Somit kann auch mittels der X-förmigen Federanordnung aus den beiden V-Federn 94 ein Übersprechen, das heißt eine unerwünschte Kopplung zwischen den beiden Verstellbewegungen der Spiegelplatte 10, unterbunden werden. Des Weiteren können die V-Federn 94 über eine Uförmige Federanbindung 96 mit dem Außenrahmen 55 verbunden sein.

Die in Figur 11 nur schematisch wiedergegebenen inneren Aktor-Elektrodenkomponenten 26 weisen an ihren der benachbarten Zwischenfeder 52 zugewandten Seite eine Einbuchtung auf, welche die Zwischenfeder 52 zumindest teilweise umgreift. Somit verläuft zumindest ein Teilabschnitt der Zwischenfeder 52 innerhalb der Einbuchtung. Auf diese Weise können die Zwischenfedern 52 eine vorteilhafte große Länge, und damit eine niedrige erste Federsteifigkeit und eine gute Verbiegbarkeit um die zweite Drehachse 14 aufweisen, obwohl das mikromechanische Bauteil eine vergleichsweise kleine Ausdehnung entlang der zweiten Drehachse 14 hat. Zusätzlich können die Zwischenfedern 52 über die U-förmige Federanbindung 92 mit der benachbarten äußeren Aktor-Elektrodenkomponente 24 verbunden sein.

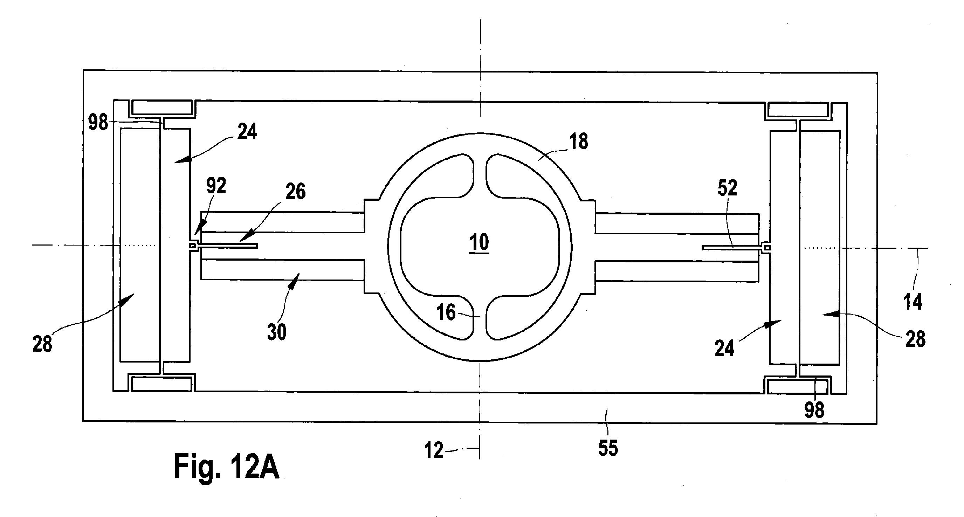

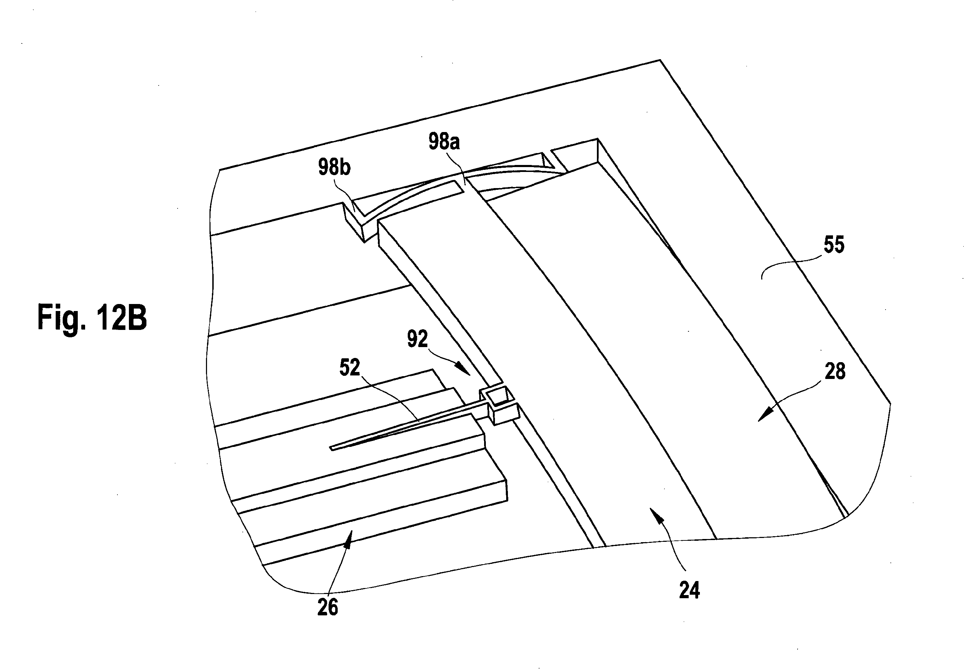

Figur 12A und 12B zeigen schematische Darstellungen einer neunten Ausführungsform des mikromechanischen Bauteils.

Das in Figur 12A in Draufsicht gezeigte mikromechanische Bauteil hat zwei äußere Aktor-Elektrodenkomponenten 24, welche jeweils über zwei beidseitig/doppelseitig eingespannte Biegefedern 98 mit dem Außenrahmen 55 verbunden sind. Wie anhand der Vergrößerung der Figur 12B zu erkennen ist, umfasst jede beidseitig eingespannte Biegefeder 98 einen stegförmigen Innenabschnitt 98a und einen Außenabschnitt 98b, welcher als U-förmige Federanbindung ausgebildet ist. Der Innenabschnitt 98a kontaktiert die benachbarte äußere AktorElektrodenkomponente 24. Der den Außenrahmen 55 kontaktierende Außenabschnitt 98b ist so ausgebildet, dass ein mittlerer Abstand zwischen den beiden Außenflächen der beiden Schenkel des Außenabschnitts 98b deutlich größer als eine mittlere Breite des Innenabschnitts 98a ist. Vorzugsweise sind die beiden beidseitig eingespannten Biegefedern 98 an der äußeren Aktor-Elektrodenkomponente 24 so angeordnet, dass ihre Symmetrieachsen parallel zu der ersten Drehachse 12 ausgerichtet sind.

Über die beidseitig eingespannten Biegefedern 98 kann die gewünschte translatorische Bewegung der äußeren Aktor-Elektrodenkomponente 24 senkrecht zu den beiden Drehachsen 12 und 14 verlässlich realisiert werden.

Auch bei der Ausführungsform der Figuren 12A und 12B ist die Zwischenfeder 52 über die U-förmige Federanbindung 92 mit der benachbarten äußeren Aktor-Elektrodenkomponente 24 verbunden und verläuft zumindest teilweise durch eine in der zugehörigen inneren Aktor-Elektrodenkomponente 26 ausgebildete Einbuchtung.

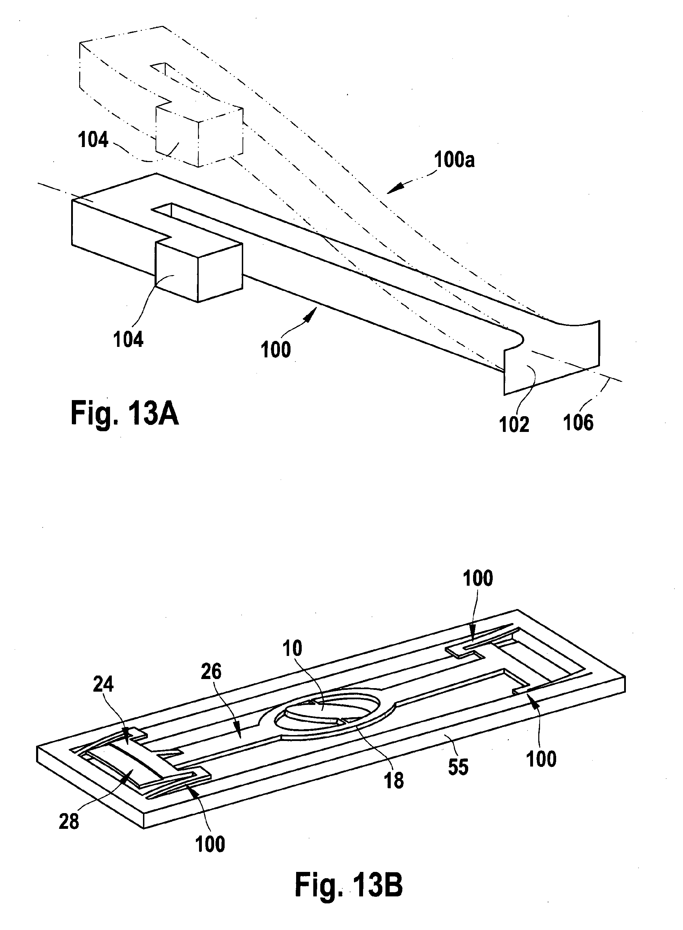

Figur 13A und 13B zeigen eine zehnte Ausführungsform des mikromechanischen Bauteils.

In Figur 13A ist eine mäanderförmige Feder 100 vergrößert dargestellt. Die mäanderförmige Feder 100 weist zumindest einen Mäander auf. Eine Ausbildung mit mehreren Windungen/Mäandern der mäanderförmigen Feder 100 ist für den Fachmann anhand der Figur 13A nahegelegt.

Die mäanderförmige Feder 100 kann an einem ersten Endabschnitt 102 an einer, beispielsweise als Außenrahmen 55 ausgebildeten Halterung befestigt werden. Ebenso kann die mäanderförmige Feder 100 an einem zweiten Endabschnitt 104 eine äußere Aktor-Elektrodenkomponente 24 kontaktieren. Vorzugsweise ist die mäanderförmige Feder 100 mit mindestens einer Untereinheit der Halterung und/oder äußeren Aktor-Elektrodenkomponente 24 aus einem Halbleitermaterial, wie beispielsweise Silizium, herausstrukturiert. Da das Herstellungsverfahren für die mäanderförmige Feder 100 für den Fachmann anhand der Fig. 13A und 13B nahegelegt ist, wird nicht genauer darauf eingegangen.

Das Anlegen einer Spannung zwischen den äußeren Elektrodenkomponenten 24 und 28 bewirkt ein Verbiegen der mäanderförmigen Feder 100 aus einer Ausgangsstellung in eine gebogene Stellung 100a.

Wie an dem in Seitenansicht dargestellten mikromechanischen Bauteil der Figur 13B zu erkennen ist, können je zwei mäanderförmige Federn 100 eine äußere Aktor-Elektrodenkomponente 24 mit dem Außenrahmen 55 verbinden. Vorzugsweise kontaktiert der erste Endabschnitt 102 der mäanderförmigen Feder 100 eine zu der ersten Drehachse 12 parallel ausgerichtete Innenfläche des Außenrahmens 55. Der zweite Endabschnitt 104 kann eine zu der zweiten Drehachse 14 parallel ausgerichtete Außenfläche der zugeordneten äußeren AktorElektrodenkomponente 24 kontaktieren.

Jede der beiden mäanderförmigen Federn 100 einer äußeren Aktor-Elektrodenkomponente 24 kontaktiert die zugeordnete äußere Aktor-Elektrodenkomponente 24 auf einer anderen Seite der zweiten Drehachse 14. Die Längsrichtungen 106 der mäanderförmigen Federn 100 sind parallel zu der zweiten Drehachse 14 ausgerichtet.

Durch das Zusammenwirken der beiden mäanderförmigen Federn 100 der gleichen äußeren Aktor-Elektrodenkomponente 24 ist eine Federaufhängung realisiert, welche eine vorteilhafte kleine erste Biegesteifigkeit bezüglich der zu den beiden Drehachsen 12 und 14 senkrecht ausgerichteten ersten Verstellbewegung der äußeren Aktor-Elektrodenkomponente 24 aufweist. Die zweite Biegesteifigkeit der Federaufhängung bezüglich einer zweiten Verstellbewegung der äußeren Aktor-Elektrodenkomponente 24, welche nicht parallel zu der ersten Verstellbewegung ausgerichtet ist, ist signifikant größer.

In Summe ergeben somit die Biegelinien der beiden mäanderförmigen Federn 100 ein Gesamtfederverhältnis, welches eine translatorische Bewegung der äußeren Aktor-Elektrodenkomponenten 24 senkrecht zu den beiden Drehachsen 12 und 14 favorisiert und das Übersprechen verhindert.

Bei einer rein translatorischen Bewegung der äußeren Aktor-Elektrodenkomponenten 24 werden keine lateralen Bewegungen der äußeren Aktor-Elektrodenkomponenten 24, welche die angestrebten Bewegungen der Spiegelplatte 10 stören, erzeugt. Damit entfällt ein beim Stand der Technik auftretender zusätzlicher Energieeintrag, der in die unerwünschte laterale Bewegung investiert wird. Somit erhält man bei den hier beschriebenen Ausführungsformen einen optimalen Energieeintrag.

Zusätzlich ist die erzeugte elektrostatische Kraft proportional zu der Flächenänderung der Elektrodenkomponenten 24 bis 30. Bei einer rein translatorischen Bewegung der äußeren Aktor-Elektrodenkomponenten 24 erhält man eine Flächenänderung zwischen den äußeren Elektrodenkomponenten 24 und 28 proportional zu der Länge der Elektrodenfinger 24a und 28a. Bei der ungewollten Drehbewegung der äußeren Aktor-Elektrodenkomponenten 24 ist die Flächenänderung halb so groß.

Durch einen zusätzlichen lateralen Bewegungsanteil wird auch der nutzbare Anteil der Anregungsbewegung reduziert. Außerdem bewirkt ein zusätzlicher lateraler Bewegungsanteil eine Verschiebung des Mittelpunkts der Spiegelplatte 10, was eine Vergrößerung der Spiegelplatte 10 erforderlich macht, um sicherzustellen, dass ein Lichtstrahl während der Verstellbewegung der Spiegelplatte auf die Oberfläche der Spiegelplatte 10 trifft. Mittels der hier beschriebenen Ausbildungsformen und Weiterbildungen ist dieser Nachteil des Stands der Technik umgehbar.

Zusätzlich zu der Form der Außenfedern können auch die Aufhängungspunkte der Außenfedern variiert werden, um eine rein translatorische, das heißt senkrecht zu den beiden Drehachsen 12 und 14 gerichtete Bewegung der äußeren Aktor-Elektrodenkomponenten 24 zu realisieren. Da derartige Modifikationen der hier dargestellten Ausführungsformen für den Fachmann durch die Figuren nahegelegt sind, wird nicht weiter darauf eingegangen.

## Patentansprüche

1. Mikromechanisches Bauteil mit:
einer Halterung (55);
einem verstellbaren Element (10);
einer äußeren Stator-Elektrodenkomponente (28) und einer äußeren Aktor-Elektrodenkomponente (24), wobei die äußere Aktor-Elektrodenkomponente (24) über mindestens eine Außenfeder (53,81,90,94,98,100) mit der Halterung (55) verbundenen ist und das verstellbare Element (10) so an die äußere Aktor-Elektrodenkomponente (24) gekoppelt ist, dass das verstellbare Element (10) in Bezug auf die Halterung (55) über ein Anlegen einer ersten Spannung zwischen der äußeren Aktor-Elektrodenkomponente (24) und der äußere Stator-Elektrodenkomponente (28) um eine erste Drehachse (12) verstellbar ist; und
einer inneren Stator-Elektrodenkomponente (30) und einer inneren Aktor-Elektrodenkomponente (26), wobei die innere Aktor-Elektrodenkomponente (26) einen ersten Steg (50) mit mindestens einem angeordneten Elektrodenfinger (26a,26b) umfasst und der erste Steg (50) entlang einer zu der ersten Drehachse (12) nicht-parallelen zweiten Drehachse (14) ausgerichtet ist, und wobei das verstellbare Element (10) so an die innere Aktor-Elektrodenkomponente (26) gekoppelt ist, dass das verstellbare Element (10) in Bezug auf die Halterung (55) über ein Anlegen einer zweiten Spannung zwischen dem mindestens einen Elektrodenfinger (26a,26b) der inneren Aktor-Elektrodenkomponente (26) und der inneren Stator-Elektrodenkomponente (30) um die zweite Drehachse (14) verstellbar ist;
**gekennzeichnet durch**
eine entlang der zweiten Drehachse (14) ausgerichtete Zwischenfeder (52), über welche die innere Aktor-Elektrodenkomponente (26) mit der äußeren Aktor-Elektrodenkomponente (24) verbunden ist.

2. Mikromechanisches Bauteil nach Anspruch 1, wobei eine erste Federsteifigkeit der Zwischenfeder (52) bezüglich einer Torsion der Zwischenfeder (52) um die zweite Drehachse (14) kleiner als eine zweite Federsteifigkeit der mindestens einen Außenfeder (53,81,90,94,98,100), welche einer Drehbewegung der äußeren Aktor-Elektrodenkomponente (24) um die zweite Drehachse (14) entgegenwirkt, ist.

3. Mikromechanisches Bauteil nach Anspruch 1 oder 2, wobei die äußere Aktor-Elektrodenkomponente (24) einen zu dem ersten Steg (50) nicht-parallel ausgerichteten zweiten Steg (54) mit mindestens einem angeordneten Elektrodenfinger (24a) umfasst.

4. Mikromechanisches Bauteil nach einem der vorhergehenden Ansprüche, wobei die äußere Aktor-Elektrodenkomponente (24) eine Plattenelektrode (86) umfasst.

5. Mikromechanisches Bauteil nach einem der vorhergehenden Ansprüche, wobei eine der benachbarten äußeren Aktor-Elektrodenkomponente (24) zugewandte Seite der inneren Aktor-Elektrodenkomponente (26) eine Einbuchtung aufweist, und wobei die Zwischenfeder (52) zumindest teilweise durch die Einbuchtung verläuft.

6. Mikromechanisches Bauteil nach einem der vorhergehenden Ansprüche, wobei Elektrodenflächen (28a-1,28a-2) der äußeren Aktor-Elektrodenkomponente (24) und/oder der äußeren Stator-Elektrodenkomponente (28) von der zweiten Drehachse (14) in auf einer ersten Seite der zweiten Drehachse (14) angeordnete erste Elektrodenflächen (28a-1) und auf einer zweiten Seite der zweiten Drehachse (14) angeordnete zweite Elektrodenflächen (28a-2) unterteilt sind, und wobei die ersten Elektrodenflächen (28a-1) an mindestens eine erste Leitung so gekoppelt sind, dass ein erstes Potential an die ersten Elektrodenflächen (28a-1) anlegbar ist, und die zweiten Elektrodenflächen (28a-2) an mindestens eine zweite Leitung so gekoppelt sind, dass ein von dem ersten Potential abweichendes zweites Potential an die zweiten Elektrodenflächen (28a-2) anlegbar ist.

7. Mikromechanisches Bauteil nach Anspruch 6, wobei das mikromechanische Bauteil eine Steuereinrichtung umfasst, welche dazu ausgelegt ist, das erste Potential an die ersten Elektrodenflächen (28a-1) und das zweite Potential an die zweiten Elektrodenflächen (28a-2) anzulegen, und wobei die Steuereinrichtung zusätzlich dazu ausgelegt ist, eine Differenz zwischen dem ersten Potential und dem zweiten Potential unter Berücksichtigung einer Information bezüglich der zwischen dem mindestens einen Elektrodenfinger (26a,26b) der inneren Aktor-Elektrodenkomponente (26) und der inneren Stator-Elektrodenkomponente (30) anliegenden zweiten Spannung und/oder einer aktuellen Stellung des mindestens einen Elektrodenfingers (26a,26b) der inneren Aktor-Elektrodenkomponente (26) in Bezug auf die inneren Stator-Elektrodenkomponente (30) festzulegen.

8. Mikromechanisches Bauteil nach einem der vorhergehenden Ansprüche, wobei die mindestens eine Außenfeder (53,90,94,98) eine parallel zu der ersten Drehachse (12) ausgerichtete Feder (53,90,94,98) umfasst, welche als mäanderförmige Wippfeder (53), als Torsionsfeder (90), als V-Feder (94) und/oder als zweiseitigeingespannte Biegefeder (98) ausgebildet ist.

9. Mikromechanisches Bauteil nach einem der vorhergehenden Ansprüche, wobei die mindestens eine Außenfeder (81, 100) eine parallel zu der zweiten Drehachse (14) ausgerichtete Feder umfasst, welche als Biegefeder (81) und/oder als mäanderförmige Feder (100) ausgebildet ist.

10. Mikromechanisches Bauteil nach einem der vorhergehenden Ansprüche, wobei durch eine Form der mindestens einen Außenfeder (53,81,90,94,98,100) und/oder die Aufhängungspunkte der mindestens einen Außenfeder (53,81,90,94,98,100) die äußere Aktor-Elektrodenkomponente (24) in eine senkrecht zu der ersten Drehachse (12) und der zweiten Drehachse (14) ausgerichtete Bewegung versetzbar ist.

11. Herstellungsverfahren für ein mikromechanisches Bauteil nach Anspruch 1 mit den Schritten:
Ausbilden einer äußeren Stator-Elektrodenkomponente (28) und einer äußeren Aktor-Elektrodenkomponente (25), wobei die äußere Aktor-Elektrodenkomponente (24) über mindestens eine Außenfeder (53,81,90,94,98,100) mit einer Halterung (55) des mikromechanischen Bauteils verbundenen wird;
Ankoppeln eines verstellbaren Elements (10) so an die äußere Aktor-Elektrodenkomponente (24), dass das verstellbare Element (10) in Bezug auf die Halterung (55) bei einem Anlegen einer ersten Spannung zwischen der äußeren Aktor-Elektrodenkomponente (24) und der äußere Stator-Elektrodenkomponente (28) um eine erste Drehachse (12) verstellt wird;
Ausbilden einer inneren Stator-Elektrodenkomponente (30) und einer inneren Aktor-Elektrodenkomponente (26) mit einem ersten Steg (50) und mindestens einem an dem ersten Steg (50) angeordneten Elektrodenfinger (26a,26b), wobei der erste Steg (50) entlang einer zu der ersten Drehachse (12) nicht-parallelen zweiten Drehachse (14) ausgerichtet wird; und
Ankoppeln des verstellbaren Elements (10) so die innere Aktor-Elektrodenkomponente (26), dass das verstellbare Element (10) in Bezug auf die Halterung (55) bei einem Anlegen einer zweiten Spannung zwischen dem mindestens einen Elektrodenfinger (26a,26b) der inneren Aktor-Elektrodenkomponente (26) und der inneren Stator-Elektrodenkomponente (30) um die zweite Drehachse (14) verstellt wird;
**gekennzeichnet durch** den Schritt:
Verbinden der inneren Aktor-Elektrodenkomponente (26) mit der äußeren Aktor-Elektrodenkomponente (24) über eine entlang der zweiten Drehachse (14) ausgerichtete Zwischenfeder (52).

## Claims

1. Micromechanical component comprising:
a holder (55);
an adjustable element (10);
an outer stator electrode component (28) and an outer actuator electrode component (24), wherein the outer actuator electrode component (24) is connected to the holder (55) by means of at least one external spring (53, 81, 90, 94, 98, 100), and the adjustable element (10) is coupled to the outer actuator electrode component (24) such that the adjustable element (10) can be adjusted with respect to the holder (55) about a first rotation axis (12) by means of a first voltage being applied between the outer actuator electrode component (24) and the outer stator electrode component (28); and
an inner stator electrode component (30) and an inner actuator electrode component (26), wherein the inner actuator electrode component (26) comprises a first web (50) with at least one arranged electrode finger (26a, 26b), and the first web (50) is oriented along a second rotation axis (14) which is not parallel to the first rotation axis (12), and wherein the adjustable element (10) is coupled to the inner actuator electrode component (26) such that the adjustable element (10) can be adjusted with respect to the holder (55) about the second rotation axis (14) by means of a second voltage being applied between the at least one electrode finger (26a, 26b) of the inner actuator electrode component (26) and the inner stator electrode component (30);
**characterized by**
an intermediate spring (52) which is oriented along the second rotation axis (14) and by means of which the inner actuator electrode component (26) is connected to the outer actuator electrode component (24).

2. Micromechanical component according to Claim 1, wherein a first spring stiffness of the intermediate spring (52) with respect to a torsion of the intermediate spring (52) about the second rotation axis (14) is smaller than a second spring stiffness of the at least one external spring (53, 81, 90, 94, 98, 100) which acts in the opposite direction to a rotation movement of the outer actuator electrode component (24) about the second rotation axis (14).

3. Micromechanical component according to Claim 1 or 2, wherein the outer actuator electrode component (24) comprises a second web (54) which is not oriented parallel to the first web (50) and has at least one arranged electrode finger (24a).

4. Micromechanical component according to one of the preceding claims, wherein the outer actuator electrode component (24) comprises a plate electrode (86).

5. Micromechanical component according to one of the preceding claims, wherein a side of the inner actuator electrode component (26) which faces the adjacent outer actuator electrode component (24) has a recess, and wherein the intermediate spring (52) runs at least partially through the recess.

6. Micromechanical component according to one of the preceding claims, wherein electrode areas (28a-1, 28a-2) of the outer actuator electrode component (24) and/or of the outer stator electrode component (28) are divided by the second rotation axis (14) into first electrode areas (28a-1) which are arranged on a first side of the second rotation axis (14) and second electrode areas (28a-2) which are arranged on a second side of the second rotation axis (14), and wherein the first electrode areas (28a-1) are coupled to at least one first line such that a first potential can be applied to the first electrode areas (28a-1), and the second electrode areas (28a-2) are coupled to at least one second line such that a second potential, which differs from the first potential, can be applied to the second electrode areas (28a-2).

7. Micromechanical component according to Claim 6, wherein the micromechanical component comprises a control device which is designed to apply the first potential to the first electrode areas (28a-1) and to apply the second potential to the second electrode areas (28a-2), and wherein the control device is additionally designed to determine a difference between the first potential and the second potential taking into account an item of information relating to the second voltage which is applied between the at least one electrode finger (26a, 26b) of the inner actuator electrode component (26) and the inner stator electrode component (30) and/or taking into account a current position of the at least one electrode finger (26a, 26b) of the inner actuator electrode component (26) with respect to the inner stator electrode component (30).

8. Micromechanical component according to one of the preceding claims, wherein the at least one external spring (53, 90, 94, 98) comprises a spring (53, 90, 94, 98) which is oriented parallel to the first rotation axis (12) and which is in the form of a meandering rocker spring (53), a torsion spring (90), a V-spring (94) and/or a bending spring (98) which is clamped in on two sides.

9. Micromechanical component according to one of the preceding claims, wherein the at least one external spring (81, 100) comprises a spring which is oriented parallel to the second rotation axis (14) and which is in the form of a bending spring (81) and/or a meandering spring (100).

10. Micromechanical component according to one of the preceding claims, wherein the outer actuator electrode component (24) can be moved in a manner oriented perpendicular to the first rotation axis (12) and the second rotation axis (14) by virtue of a shape of the at least one external spring (53, 81, 90, 94, 98, 100) and/or the suspension points of the at least one external spring (53, 81, 90, 94, 98, 100).

11. Production method for a micromechanical component according to Claim 1, comprising the steps of:
forming an outer stator electrode component (28) and an outer actuator electrode component (25), wherein the outer actuator electrode component (24) is connected to a holder (55) of the micromechanical component by means of at least one external spring (53, 81, 90, 94, 98, 100) ;
coupling an adjustable element (10) to the outer actuator electrode component (24) such that the adjustable element (10) is adjusted with respect to the holder (55) about a first rotation axis (12) when a first voltage is applied between the outer actuator electrode component (24) and the outer stator electrode component (28);
forming an inner stator electrode component (30) and an inner actuator electrode component (26) with a first web (50) and at least one electrode finger (26a, 26b) which is arranged on the first web (50), wherein the first web (50) is oriented along a second rotation axis (14) which is not parallel to the first rotation axis (12); and
coupling the adjustable element (10) to the inner actuator electrode component (26) such that the adjustable element (10) is adjusted with respect to the holder (55) about the second rotation axis (14) when a second voltage is applied between the at least one electrode finger (26a, 26b) of the inner actuator electrode component (26) and the inner stator electrode component (30);
**characterized by** the step of:
connecting the inner actuator electrode component (26) to the outer actuator electrode component (24) by means of an intermediate spring (52) which is oriented along the second rotation axis (14).

## Revendications

1. Composant micromécanique présentant :
un support (55),
un élément ajustable (10),
un composant extérieur (28) d'électrode de stator et un composant extérieur (24) d'électrode d'actionneur, le composant extérieur (24) d'électrode d'actionneur étant raccordé au support (55) par l'intermédiaire d'au moins un ressort extérieur (53, 81, 90, 94, 98, 100) et l'élément ajustable (10) étant accouplé au composant extérieur (24) d'électrode d'actionneur de telle sorte que l'élément ajustable (10) puisse, par application d'une première tension entre le composant extérieur (24) d'électrode d'actionneur et le composant extérieur (28) d'électrode de stator, être déplacé par rapport au support (55) autour d'un premier axe (12) et
un composant intérieur (30) d'électrode de stator et un composant intérieur (26) d'électrode d'actionneur, le composant intérieur (26) d'électrode d'actionneur comportant une première nervure (50) sur laquelle est disposé un doigt d'électrode (26a, 26b), la première nervure (50) étant orientée suivant un deuxième axe (14) non parallèle au premier axe (12),
l'élément ajustable (10) étant couplé au composant intérieur (26) d'électrode d'actionneur de telle sorte que l'élément ajustable (10) puisse, par application d'une deuxième tension entre le ou les doigts d'électrode (26a, 26b) du composant intérieur (26) d'électrode d'actionneur et le composant intérieur (30) d'électrode de stator, être déplacé par rapport au support (55) autour du deuxième axe (14),
**caractérisé par**
un ressort intermédiaire (52) orienté suivant le deuxième axe (14) et par lequel le composant intérieur (26) d'électrode d'actionneur est relié au composant extérieur (24) d'électrode d'actionneur.

2. Composant micromécanique selon la revendication 1, dans lequel une première rigidité du ressort intermédiaire (52) dans le sens d'une torsion du ressort intermédiaire (52) autour du deuxième axe (14) est inférieure à une deuxième rigidité du ou des ressorts extérieurs (53, 81, 90, 94, 98, 100) qui s'opposent à un déplacement de rotation du composant extérieur (24) d'électrode d'actionneur autour du deuxième axe de rotation (14).

3. Composant micromécanique selon les revendications 1 ou 2, dans lequel le composant extérieur (24) d'électrode d'actionneur comporte une deuxième nervure (54) orientée dans une direction non parallèle à la première nervure (50) et sur laquelle est disposé au moins un doigt d'électrode (24a).

4. Composant micromécanique selon l'une des revendications précédentes, dans lequel le composant extérieur (24) d'électrode d'actionneur comporte une électrode (86) en plaque.

5. Composant micromécanique selon l'une des revendications précédentes, dans lequel un côté du composant intérieur (26) d'électrode d'actionneur tourné vers le composant extérieur voisin (24) d'électrode d'actionneur présente une entaille, le ressort intermédiaire (52) traversant l'entaille au moins en partie.

6. Composant micromécanique selon l'une des revendications précédentes, dans lequel des surfaces (28a-1, 28a-2) du composant extérieur (24) d'électrode d'actionneur et/ou du composant extérieur (28) d'électrode de stator sont divisées par le deuxième axe de rotation (14) en premières surfaces d'électrode (28a-1) disposées sur un premier côté du deuxième axe de rotation (14) et en deuxièmes surfaces d'électrode (28a-2) disposées sur un deuxième côté du deuxième axe de rotation (14), les premières surfaces d'électrode (28a-1) étant raccordées à au moins un premier conducteur de telle sorte qu'un premier potentiel puisse être appliqué sur les premières surfaces d'électrode (28a-1), les deuxièmes surfaces d'électrode (28a-2) étant raccordées à au moins un deuxième conducteur de telle sorte qu'un deuxième potentiel, différent du premier potentiel, puisse être appliqué sur les deuxièmes surfaces d'électrode (28a-2).

7. Composant micromécanique selon la revendication 6, dans lequel le composant micromécanique comporte un dispositif de commande conçu pour appliquer le premier potentiel sur les premières surfaces d'électrode (28a-1) et le deuxième potentiel sur les deuxièmes surfaces d'électrode (28a-2), le dispositif de commande étant de plus conçu pour définir entre le premier potentiel et le deuxième potentiel une différence qui tient compte d'une information concernant la deuxième tension appliquée entre le ou les doigts d'électrode (26a, 26b) du composant intérieur (26) d'électrode d'actionneur et le composant intérieur (30) d'électrode de stator et/ou la position effective du ou des doigts d'électrode (26a, 26b) du composant intérieur (26) d'électrode d'actionneur par rapport au composant intérieur (30) d'électrode de stator.

8. Composant micromécanique selon l'une des revendications précédentes, dans lequel le ou les ressorts extérieurs (53, 90, 94, 98) comportent un ressort (53, 90, 94, 98) orienté parallèlement au premier axe de rotation (12) et configuré comme ressort (53) en méandre, ressort de torsion (90), ressort en V (94) et/ou ressort de flexion (98) serré sur deux côtés.

9. Composant micromécanique selon l'une des revendications précédentes, dans lequel le ou les ressorts extérieurs (81, 100) comportent un ressort orienté parallèlement au deuxième axe de rotation (14) et configuré comme ressort de flexion (81) et/ou comme ressort (100) en méandre.

10. Composant micromécanique selon l'une des revendications précédentes, dans lequel le composant extérieur (24) d'électrode d'actionneur peut être déplacé dans une direction orientée perpendiculairement au premier axe de rotation (12) et au deuxième axe de rotation (14) par la forme du ou des ressorts extérieurs (53, 81, 90, 94, 98, 100) et/ou par les points de suspension du ou des ressorts extérieurs (53, 81, 90, 94, 98, 100).

11. Procédé de fabrication d'un composant micromécanique selon la revendication 1, le procédé comportant les étapes qui consistent à :
former un composant extérieur (28) d'électrode de stator et un composant extérieur (25) d'électrode d'actionneur, le composant extérieur (24) d'électrode d'actionneur étant raccordé par au moins un ressort extérieur (53, 81, 90, 94, 98, 100) à un support (55) du composant micromécanique,
accoupler un premier élément ajustable (10) au composant extérieur (24) d'électrode d'actionneur de telle sorte que l'élément ajustable (10) soit, sous l'application d'une première tension entre le composant extérieur (24) d'électrode d'actionneur et le composant extérieur (28) d'électrode de stator, déplacé par rapport au support (55) autour d'un premier axe de rotation (12),
former un composant intérieur (30) d'électrode de stator et un composant intérieur (26) d'électrode d'actionneur comportant une première nervure (50) et au moins un doigt d'électrode (26a, 26b) disposé sur la première nervure (50), la première nervure (50) étant orientée suivant un deuxième axe de rotation (14) non parallèle au premier axe de rotation (12) et
accoupler l'élément ajustable (10) au composant intérieur (26) d'électrode d'actionneur de telle sorte que sous l'application d'une deuxième tension entre le ou les doigts d'électrode (26a, 26b) du composant intérieur (26) d'électrode d'actionneur et le composant intérieur (30) d'électrode de stator, l'élément ajustable (10) soit déplacé par rapport au support (55) autour du deuxième axe (14),
**caractérisé par** l'étape qui consiste à :
raccorder le composant intérieur (26) d'électrode d'actionneur au composant extérieur (24) d'électrode d'actionneur par l'intermédiaire d'un ressort intermédiaire (52) orienté suivant le deuxième axe de rotation (14).
